# EUROPEAN PATENT APPLICATION

(11) **EP 4 761 551 A1**
(43) Date of publication of application: **17.06.2026**
(21) Application number: 24219789.5
(22) Date of filing: 13.12.2024
(51) Int. Cl.: H10K 85/30, H10K 50/11, H10K 50/17

(54) **METAL ORGANIC COORDINATION COMPOUND, ORGANIC ELECTROLUMINESCENT DEVICE AND METHOD FOR PRODUCING THE SAME**

(71) Applicant: beeOLED GmbH, 01217 Dresden (DE)
(72) Inventor: SENKOVSKYY, Volodymyr, Dresden, 01187 (DE)
(74) Representative: Altmann Stößel Dick Patentanwälte PartG mbB

(57) **Abstract**

An organic electroluminescent device comprises a first electrode, a second electrode, and an organic layer disposed between the first electrode and the second electrode,
the organic layer comprising at least one charge-neutral metal-organic coordination compound, with the metal-organic coordination compound comprising at least one electrically negatively charged gallium compound of general formula (1-1): 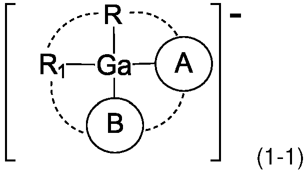 with A, and B independently being substituted or non-substituted heterocyclic rings, and broken lines indicating e.g. a chemical bond or linking group at any available position.

## Description

### Technical Field

The invention concerns a metal-organic coordination compound, wherein the coordination compound comprises a gallium containing coordinating anion, an organic electronic device containing same, and methods for forming the same in particular using thermal evaporation or sublimation or casting from solution.

### Background

Electroluminescent devices that make use of organic light emitting diodes (OLEDs) are state-of-the-art for flat panel display applications used in everyday consumer electronics. For OLEDs, a variety of materials is employed to fulfill specific functions within the device. For many such functions, such as charge transport, light generation, electrical doping, charge injection, it is desirable to use redox active metals. Those metals are always used in the form of metal-organic complexes to allow for good layer formation within the organic device. Various metals, such as d-metals, can form covalent bonds with suitable organic ligands. Yet, other interesting metals, such as lanthanides, may not form covalent bonds, but instead form coordination compounds with coordinating ligands. To ensure stable device operation, strong chemical bonds and high temperature stability are desirable. The later, often quantified in terms of the glass transition temperature, is typically improved by using large, bulky organic fragments. The ligand binding strength is high, if the ligands is simultaneously electrostatically and coordinatively bound to the central metal, in other words, coordinating anions are preferred for complex design.

An archetypical coordinating anion often employed for OLED materials are pyrazolyl borate, which in combination with lanthanide cations has for example been disclosed in WO98/55561 A1. Through one of the nitrogens present within the pyrazolyl fragment, this particular class of anions can form stable coordination bonds with the central metal cation. Here, the situation is much less favorable for the aryl type borate anions based on for example tetra-phenyl borate, which form much weaker metal to anion bonds.

Whilst stable bonds are formed between the coordinating pyrazolyl-borate anion and the central metal cation, the very presence of some cations actually weakens the pyrazolyl-borate bond within the anion, a phenomenon that is known as ligand scrambling (see Bieller et al. / Inorg. Chim. Acta 359 (2006) 1559 and Kharbani et al. / Journal of Molecular Structure 1133 (2017) 264). This degradation is specifically pronounced for strongly redox active metals, such as Cerium(III). This particular cation with its deep blue doublet transition has often been proposed as deep blue emitter for OLED, which could elegantly circumvent the singlet-triplet generation yield by harvesting all electrical excitations leading to high light generation efficiencies.

An object underlying the present invention is to provide anions that are thermally so robust that they can be processed by sublimation, that are not highly fluorinated in order to comply with the PFAS ban that is currently rolled out in many nations, that have a high triplet energy so that they can be used to generate deep blue light form all electrical excitations within the OLED device, and that feature heteroatoms capable of forming stable coordination bonds with metal cations, such as three-valent lanthanides.

The objectives are achieved according to the present invention by using specific gallium containing anions instead of borates.

Gallium containing anions can per se be known compounds. In WO2018/085055 A1 tetraaryl gallium containing compounds are proposed as counter anions for use in transport or injection layers of electroluminescent devices. However, these highly fluorinated anions cannot be used to form stable coordination compounds as they are in fact designed to be weakly coordinating anions. According to the present invention, the objectives are most elegantly achieved by using gallium containing anions that are covalently bound to four atoms or organyl groups of which at least two are heteroaryl rings such that the heteroatoms present in the heteroaryl rings can form stable coordination bonds towards the metal cation. Gallium forms much more robust bonds as compared to boron, making such gallium containing compounds at the same time thermally robust and well coordinating.

The objectives are specifically achieved according to the present invention by an organic electroluminescent device comprising:
a first electrode,
a second electrode, and
an organic layer disposed between the first electrode and the second electrode,
the organic layer comprising at least one charge-neutral metal-organic coordination compound, with the metal-organic coordination compound comprising at least one electrically negatively charged gallium compound of general formula (1-1): 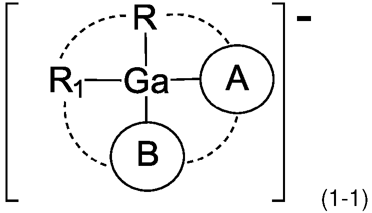 with
   - **A,** and **B** independently being substituted or non-substituted heterocyclic rings, preferably aromatic heterocycles which preferably comprise one or more nitrogen ring atoms, and
   - **R** and **R₁** independently in each instance representing hydrogen, deuterium, or organyl groups, and
   - **broken lines** between the rings A and B and between the ring B and an organyl fragment R₁, and between the ring A and an organyl fragment R, and between two organyl fragments R and R₁ indicate each independently either that those respective organyl fragments A, B, R and R1 are not connected at any position, or that those respective organyl fragments A, B, R and R1 are directly connected through a chemical bond at any available position of each, or that those respective organyl fragments A, B, R and R1 are connected via a linking group at any available position of each;
in a preferred embodiment the electroluminescent device according to the invention comprising the metal organic coordination compound according to formula (1-1) at least one, preferably both, of the rings A and/or B are independently, preferably identically, selected from the group consisting of substituted or non-substituted imidazole-2-yl, imidazole-4-yl, pyrazolyl, 1,2,3-triazolyl, 1,2,4-triatolyl, thiazolyl, isothiazolyl, oxazolyl, 1,3,4-oxadiazole-yl, and 1,2,4-thiadiazolyl;
in another embodiment both heterocyclic rings A, and B each identically are identically substituted pyrazolyl, preferably with substitutions in 3- and 5- position, and even more preferably with an identical substituent in the 3- and the 5- position, and even more preferably the substituent being alkyl or heteroalkyl, most preferably methyl or ethyl. In a preferred embodiment R and R₁ each independently are selected from substituted or non-substituted alkyl, preferably non-substituted alkyl, most preferably methyl, ethyl, or propyl, or being selected from substituted or non-substituted aryl or heteroaryl, preferably pyrazolyl or phenyl, the phenyl preferably being a mesityl.

The objectives will further be achieved by an electroluminescent device comprising a metal organic coordination compound, comprising at least one gallium containing compound anion with the metal-organic coordination compound comprising the at least one electrically negatively charged gallium compound being of general formula (1-4) 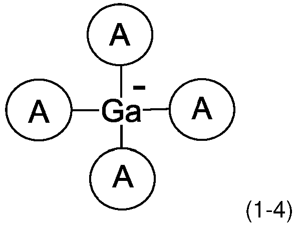
with **A** being identical, substituted or non-substituted heterocyclic rings, preferably aromatic heterocycles, preferably comprising one or more nitrogen ring atoms more preferably being substituted or non-substituted pyrazolyl,
or with the metal-organic coordination compound comprising at least one electrically negatively charged gallium compound being of general formula (1-2): 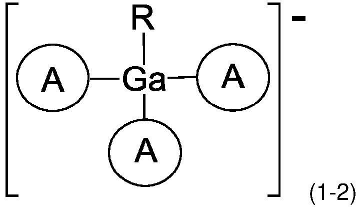
with **A** being identical, substituted or non-substituted heterocyclic rings, preferably aromatic heterocycles, preferably comprising one or more nitrogen ring atoms more preferably being substituted or non-substituted pyrazolyl, R representing hydrogen, deuterium, or an organyl group!, preferably aryl, more preferably mesityl,
or with the metal-organic coordination compound comprising at least one electrically negatively charged gallium compound being of general formula (1-3): 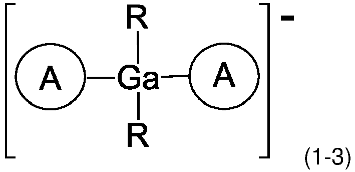
with both **A** being identical, substituted or non-substituted heterocyclic rings, preferably aromatic heterocycles, preferably comprising one or more nitrogen ring atoms , more preferably substituted or non-substituted pyrazolyl, both **R** being identical, representing hydrogen, deuterium, or organyl groups, preferably aryl, more preferably mesityl.

Thus, the gallium containing compound anions preferably contain 2 to 4 groups A, which preferably are identical, and 0 to 2 groups R which preferably are identical, and 4 groups in total. More preferably, 2 or 3 groups A are present, and 1 or 2 groups R, resulting in 4 groups in total.

Preferably, the gallium containing compound anions present in the charge-neutral metal organic coordination compound being present in the electroluminescent device according to the invention are selected from G1 to G15:

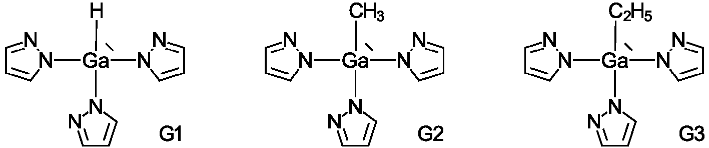

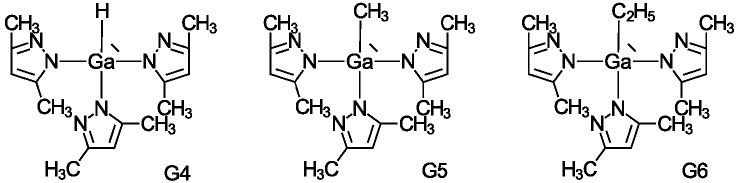

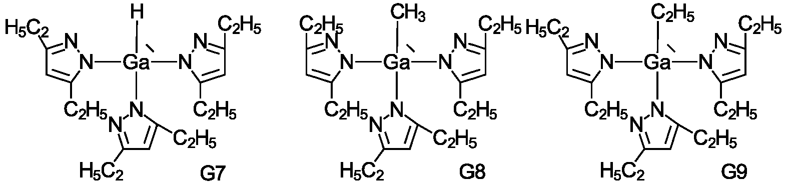

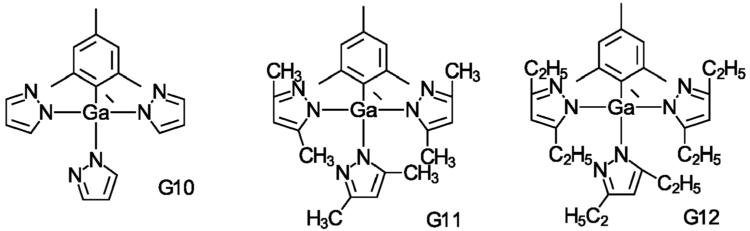

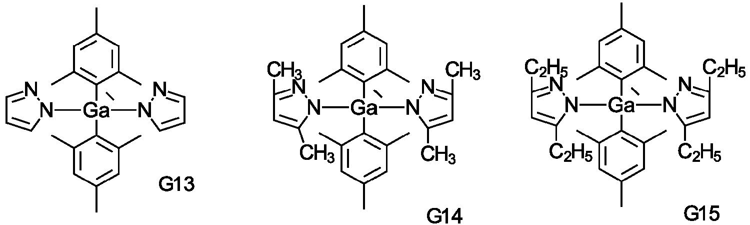

The objectives are furthermore achieved according if the metal-organic coordination compound comprises at least one more metal besides the Gallium, with this at least one second metal being formally electrically positively charged, i.e. being a cation, and preferably being selected from the group of alkali or alkali earth metals, lanthanides, or a transition metals, preferably alkali metals or lanthanides;
or with the at least one second metal being twofold or higher electrically positively charged and with the metal-organic coordination compound comprising one or more charge-neutral or electrically negatively charged ligand(s), which are not Gallium containing compounds.

Preferably this at least one additional metal is electrically positively charged, and preferably being selected from the group consisting of alkali metals, alkali earth metals, lanthanides, and transition metals, preferably being selected from the group consisting of alkali metals and lanthanides, preferably with the at least one additional metal cation, present as part of the metal-organic coordination compound being twofold or higher electrically positively charged and with the metal-organic coordination compound comprising one or more charge-neutral or electrically negatively charged ligands, which are different from the electrically negatively charged gallium compounds of formulae (1-1), (1-2) and (1-3).

Preferably, the at least one additional metal cation being threefold positively charged and with the coordination compound comprises two, preferably identical, electrically negatively charged gallium compounds according to formula (1-1), (1-2) or (1-3) as ligands and a third singly electrically negatively charged ligand, which is preferably identical to the ring A or B present in any of the formulae (1-1), (1-2) or (1-3), or is a substituted ring A or B thereof.

Preferably, the metal being threefold positively charged and the coordination compound comprise two, preferably identical, gallium containing compounds derived from the generic formula (1-1) and a third singly electrically negatively charged ligand, which is preferably identical with or a substituted derivative of any of the rings A, or B present in any of the two gallium containing compounds derived from formula (1-1).

The objective is further achieved when the organic layer that comprises the gallium (containing compound) containing metal organic coordination compound according to the invention further comprises at least one phosphorescent light emitting material. Preferably the phosphorescent light emitting material emits substantially in the blue spectral region, and/or comprises a metal cation selected from Pt(II) or Ir(III) and/or further comprises at least one fluorescent, hyperfluorescent, or TADF-type emitting organic material. In particular, the fluorescent material can comprise one or more six-membered heteroaryl or heteroalkyl rings comprising one or more bon atoms in combination with nitrogen and/or Oxygen atoms as part of the ring-forming atoms.

At least part of the coordination compounds included in the electroluminescent device are not known from the prior art.

Accordingly the objectives are further achieved according to the present invention by a coordination compound that comprises at least one lanthanide cation with the at least one lanthanide cation being coordinated by at least one organic ligand derived from the generic formula (1-1): 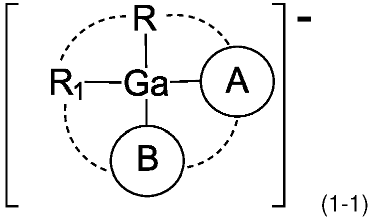 with
- A, and B independently being substituted or non-substituted heterocyclic rings, preferably aromatic heterocycles which preferably comprise one or more nitrogen ring atoms, and
- R and R1 independently in each instance representing hydrogen, deuterium, or organyl groups, and
- broken lines between the rings A and B and between the ring B and an organyl fragment R1, and between the ring A and an organyl fragment R, and between two organyl fragments R and R1 indicate each independently either that those respective organyl fragments A, B, R and R1 are not connected at any position, or that those respective organyl fragments A, B, R and R1 are directly connected through a chemical bond at any available position of each, or that those respective organyl fragments A, B, R and R1 are connected via a linking group at any available position of each.

Thus, A, and B, and R, and R1 and the broken lines have the same definitions as given above.

Preferably,the at least one lanthanide cation isselected from La(III), Ce(IV), Ce(III), Pr(III), Nd(III), Sm(III), Eu(II), Eu(III), Gd(III), Tb(III), Dy(III), Ho(III), Er(III), Tm(III), Yb(II), Yb(III), or Lu(III), and more preferably is Ce(lll) or Gd(III).

Preferably, the at least one lanthanide cation is threefold electrically positively charged, and more preferably is associated with three coordinating gallium (containing compound) counter anions according to formula (1-1).

Preferably the at least one lanthanide cation is threefold electrically positively charged and coordinated by three identical or different electrically negatively charged gallium compounds of general formula (1-1) as ligands, preferably the three electrically negatively charged gallium compounds of general formula (1-1) as ligand being identical to each other, more preferably the rings A and B in general formula (1-1) being identical to each other.

Preferably the at least one lanthanide cation is threefold electrically positively charged and coordinated by two identical or different electrically negatively charged gallium compounds of general formula (1-1) and a third singly electrically negatively charged compound which is not a gallium compound as ligands, preferably the two electrically negatively charged gallium compounds of general formula (1-1) being identical to each other, more preferably the rings A and B present in formula (1-1) of the electrically negatively charged gallium compounds of general formula (1-1) being identical to each other, and preferably the third singly electrically negatively charged compound being preferably identical to the rings A, or B present in formula (1-1) of the electrically negatively charged gallium compounds of general formula (1-1), or being a substituted ring A or B thereof.

Preferably, the three gallium containing compound anions are identical, more preferably the rings A, and B are identical to each other. Alternatively, preferably with the at least one lanthanide cation being threefold electrically positively charged there are two coordinating gallium containing compound counter anions according to formula (1-1) present and there is a third singly electrically negatively charged ligand present, which is not a gallium containing compound and as such not described by formula (1-1).

Preferably the two gallium containing compound anions are identical, more preferably the rings A, and B are identical and preferably the third singly electrically negatively charged ligand being not a gallium containing compound is identical or a substituted derivative of any of the rings A, or B present in any of the two gallium containing compounds.

The objectives are further achieved by the metal organic coordination compounds selected from C1 to C15 and using them in the electroluminescent device :

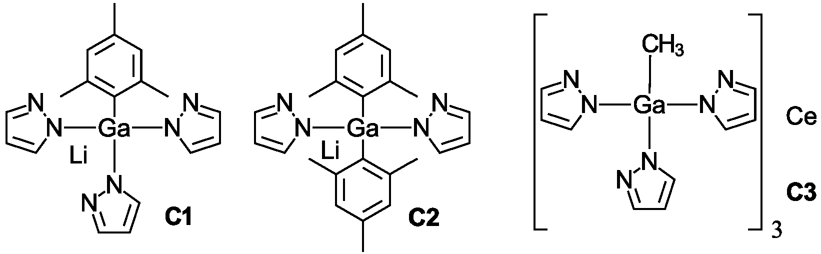

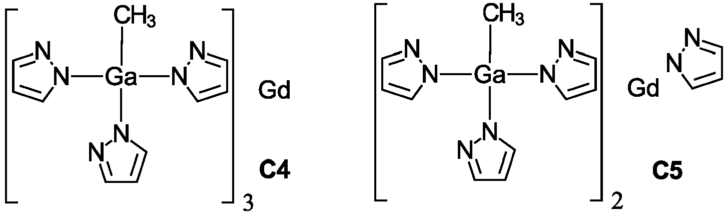

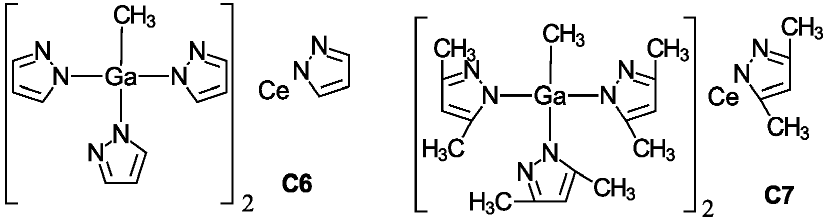

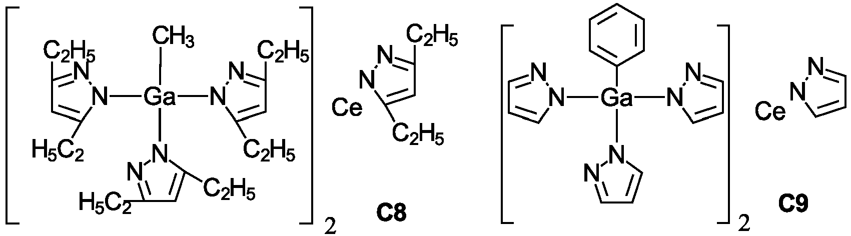

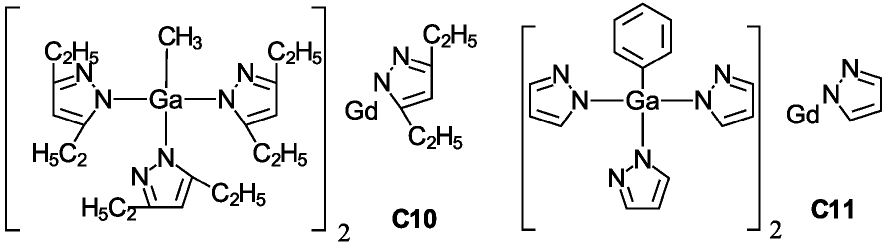

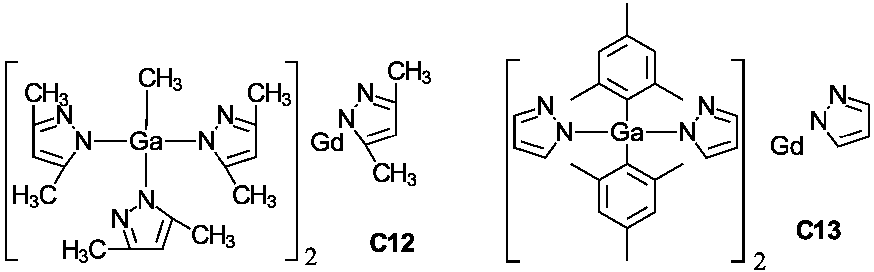

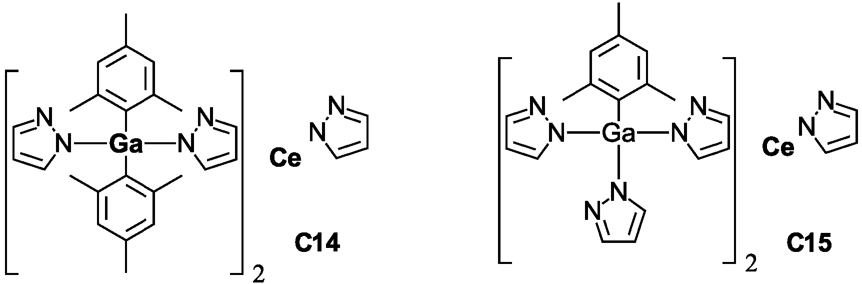

In various preferred embodiments, electroluminescent devices comprising any of the metal organic coordination compounds or gallium containing compound according to the invention are deposited from gas phase, preferably using an evaporation and/or sublimation and/or carrier gas process or by deposition from solution.

The present invention relates to the use of specific gallium containing compound type anions to design metal organic coordination compounds. The gallium containing compound anions may be very volatile even without using any fluorination or fluorinated side groups. As such, the coordination compounds may as well show high volatility making them suitable for evaporation or sublimation processing and various examples are presented in this invention. The anions exhibit heterocyclic, preferably aromatic, units capable of coordination with high bond strength, making them very useful to coordinate lanthanide cations. For electroluminescent devices, of specific interest are blue emitters, for example derived from the doublet optical transition of Ce(III). In this context the gallium containing compound anions according to the invention have sufficient high triplet energy to allow for the generation of deep blue emission and various highly efficient electroluminescent devices are demonstrated within this invention. Further, the gallium-based anions often show superior chemical and physical stability allowing for the design of electroluminescent devices with high operational stability. Finally, the synthesis of the gallium containing compound type anions is very straightforward with many concrete examples being in detail presented as part of this disclosure.

The combination of the properties mentioned enables the design of very efficient deep blue emitting OLED devices with high operational stability. As such, emitting compounds comprising the anions according to the invention are ideally suited as active emitting materials in electroluminescent consumer electronics applications.

### Summary of the invention

In various aspects of this invention, metal-organic coordination compounds coordinated by one or more gallium containing compound anions, methods for synthesizing those gallium containing compounds and corresponding coordination compounds as well as electroluminescent devices containing the same are provided.

The objective is achieved by an electroluminescent device comprising a coordination compound comprising one or more gallium containing compound type anions as defined above and in claim 1. The gallium containing compound has four covalent bonds to individual atoms or organyl groups making it a singly electrically negatively charged anion. The chemical stability between the gallium and various organyl fragments can be superior as compared to the boron derivatives, respectively. Therefore, using gallium containing compound coordinating anions as compared to boron coordinating anions may offer improved operational stability if used in electroluminescent devices. The negatively charged anion naturally does form an electrostatic bond with any central metal cation. Yet, an improved complex stability can be achieved according to this invention, if the gallium containing compound ligand provides for additional coordination bonds by means of heterocyclic, preferably aromatic, rings. This is particularly crucial, if the central metal does not from any covalent bonds with anionic or neutral ligands, such as with lanthanides. At least two heterocyclic rings must be present in the gallium containing compound to allow for stable coordination bonds with the central metal cation and those two hetercyclic rings are labeled as "A" and "B" in the generic formula (1-1) above and in claim 1. The remaining two covalent bonds of the gallium are substituted by suitable atoms or organyl fragments. Any two of the four covalent substituents on the gallium can additionally be linked with each other, which may further improve the chemical or thermal stability.

In various preferred embodiments at least one of the at least two heterocyclic rings present as part of the gallium containing compound has two or more heteroatoms present within the ring and is for example selected from a substituted or non-substituted imidazoly-2-yl, imidazole-4-yl, pyrazolyl, 1 ,2,3-triazolyl, 1 ,2,4-triatolyl, thiazolyl, and thiadiazolyl. In those heterocycles, the nitrogens or the sulfur may offer superior coordination towards the central metal cation of the metal organic coordination compound according to the invention. In various preferred embodiments the two cyclic rings A and B are identically to each other, which generally eases synthesis and offers higher chemical stability as any tendency for isomer formation is reduced. Further preferred are heterocyclic heteroaryl rings from the class of substituted pyrazolyl, preferably with substitutions in 3 and 5 position, and even more preferably with an identical substituent in the 3 and the 5 position, and even more preferably the substituent is an alkyl or heteroalkyl fragment, most preferably methyl or ethyl. The pyrazolyl in general can covalently bond with one nitrogen to the gallium, which leaves the second nitrogen for coordination towards the central metal cation. Generally preferred are substituted heterocylic rings as they offer better solubility, which eases synthesis and purification, but as well improve the thermal stability in solid devices. The covalent bond from the gallium towards both neighboring nitrogens of the pyrazolyl fragment is equal and is known that a flip between both isomers may frequently occur, especially for boron, but likely to a lesser extent for gallium too. Therefore, a symmetrical substitution on the 3 and 5 position of the pyrazolyl fragment is generally preferred as this results in identical isomers during bond flip ensuring particularly robust compounds. The substitutions themselves should not be too large and bulky as otherwise the gallium containing compound cannot be formed anymore. Therefore, the preferred substitutions are comparable small alkyl or heteralkyl fragments, in particular methyl or ethyl. Preferably R and R₁ are selected individually from a substituted or non-substituted alkyl, preferably a non-substituted alkyl, most preferably methyl, ethyl, or propyl, or selected from a substituted or non-substituted aryl or heteroaryl, preferably a pyrazolyl or phenyl, the phenyl preferably being a mesityl. Each of these preferred substitutions are not too sterically demanding thus ensuring that the gallium containing compound can still be formed.

In various embodiments the at least one gallium containing compound comprises three identical heterocylic fragments (A, B, and R₁ in formula (1-1)) and thus can be derived from the generic formula (1-2):

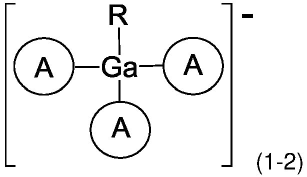

Such compounds are generally easier to synthesize and lead to lower likelihood of isomer formation during synthesis as compared to a situation with a variety of heterocyclic rings. As before, preferably, the heterocyclic fragments are preferably substituted or non-substituted pyrazolyl rings.

In various other embodiments the at least one gallium containing compound comprises two identical heterocylcic fragments (A, B in formula (1-1)) and the two other atoms or organyl fragments R and R₁ are identical to each other too, respectively. The generic formula (1-1) can thus be simplified to the specific variant (1-3): 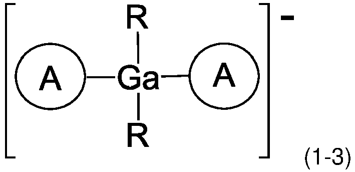 with A, and R having the same meaning as above. Again, this more symmetrical gallium containing compound is less prone to isomer formation and generally easier to synthesize. Preferably, the heterocylic fragment is a substituted or non-substituted pyrazolyl and the atoms or organyl fragments R, and R₁, are preferably aryl fragments, for example mesityl.

In various embodiments the metal organic coordination compound according to the invention comprises at least one gallium containing compound type anion G1 to G11 according to formula (1-2) and/or a gallium containing compound type anion G12 to G15 according to formula (1-3). All anions G1 to G15 use identical pyrazolyl heterocyclic heteroaryl rings. The more preferred anions have identically substituted pyrazolyl in the 3 and 5 position, specifically with methyl (G4, G5, G6, G11, and G14) or with ethyl (G7, G8, G9, G12, and G15). The substituent R can be a single atom, specifically hydrogen as exemplified in G1, G4, and G7, but more preferably it is a small alkyl chain such as methyl or ethyl, or an aryl, preferably a substituted aryl such as mesityl (compare G10 to G12).

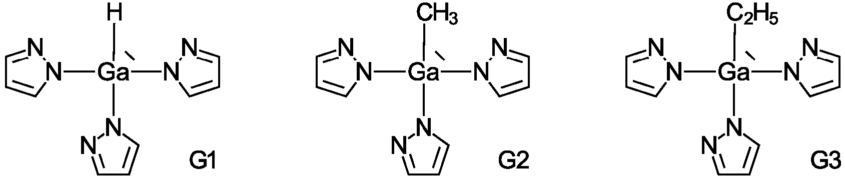

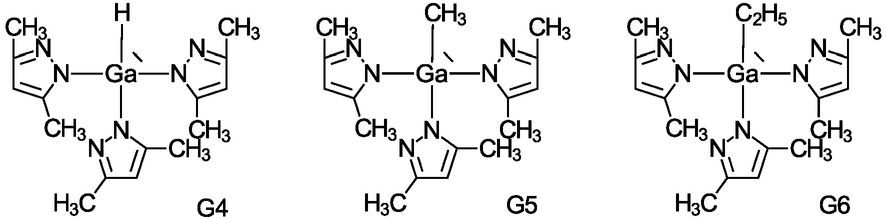

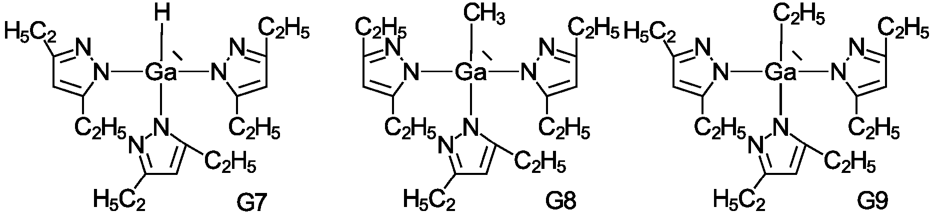

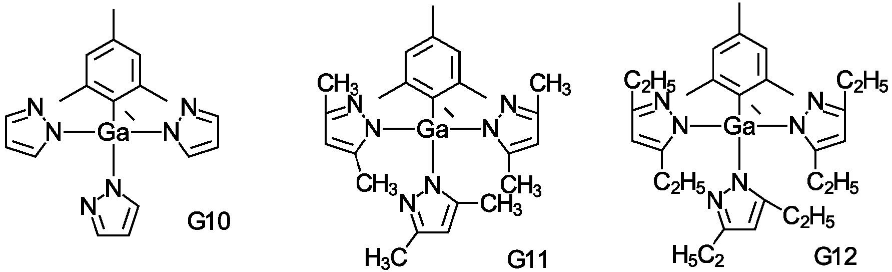

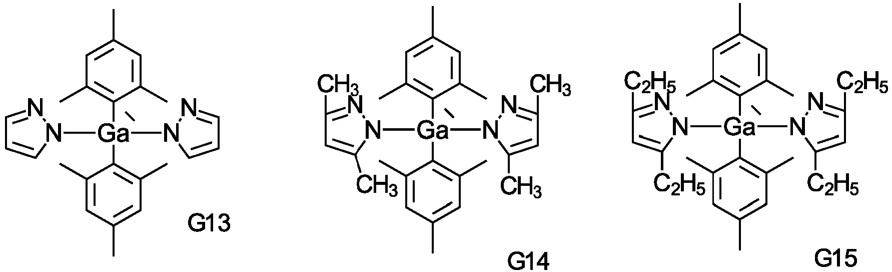

In various preferred embodiments the gallium containing compound anions according to the invention are used to form very stable charge-neutral metal-organic compounds by coordinating to a central metal cation that is not Gallium. In various embodiments the metal cation is selected from the group of alkali or alkali earth metals, lanthanides, or a transition metal, preferably alkali metals or lanthanides. The anion according to the invention can be specifically well suited to coordinate cations that do not form covalent bonds, such as lanthanides. In various embodiments the central metal cation is twofold or higher electrically positively charged and with the metal-organic coordination compound comprising one or more charge-neutral or electrically negatively charged ligand(s), which is not a gallium containing compound according to the generic formula (1-1). For example, it can be that three organic anionic ligands according to formula (1-1) can be sterically too demanding to form a stable compound with a central metal cation of oxidation stage three. In such a situation, stable compounds with one or two gallium containing compound anions and two or one, respectively, smaller anions can be formed. In a preferred embodiment those smaller anions are derived from the allium containing compound according to formula (1-1) in such a way that the smaller anion is identical to the heterocyclic rings A, and/or B or is a derivative of the latter, for example with a different substitution pattern. With the small auxiliary ligand being derived from the gallium containing compound anion, there is a reduced possibility for isomer formation, which generally improves the stability of the metal-organic coordination compounds. In various embodiments the metal cation is of oxidation stage 3+, for example a lanthanide, and there are two identical gallium containing compound anions according to the invention present and a single third singly electrically negatively charged ligand, which is preferably identical or a substituted derivative from any of the rings A, or B present in any of the two gallium containing compounds.

In various embodiments the organic layer being part of the electroluminescent device according to the invention is configured as light emission layer and comprises organic emitter compounds besides the metal organic coordination compound according to the invention. In various embodiments at least one phosphorescent emitting material is present. Preferably, the phosphorescent emitting material emits substantially in the blue spectral region, and/or comprises a metal cation selected from Pt(II) or Ir(III). In various other embodiments at least one fluorescent, hyperfluorescent, or TADF-type emitting organic material is present. Preferably, the fluorescent material comprises one or more six-membered heteroaryl or heteralkyl rings comprising one or more Bor atoms in combination with Nitrogen and/or Oxygen atoms as part of the ring

The gallium containing compound anion according to the invention can be specifically well suited to form stable coordination compounds with lanthanide metal cations. Various embodiments use charge-neutral metal-organic coordination compounds, wherein the coordination compound comprises at least one lanthanide cation with the at least one lanthanide cation being coordinated by at least one organic ligand derived from the generic formula (1-1): 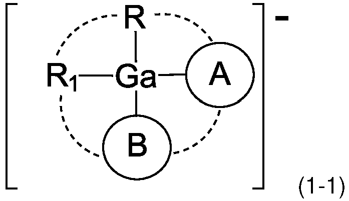 with A, and B, and R, and R1 and the broken lines having the same definitions as above. Preferably, the at least one lanthanide cation is selected from La(III), Ce(IV), Ce(III), Pr(III), Nd(III), Sm(III), Eu(II), Eu(III), Gd(III), Tb(III), Dy(III), Ho(III), Er(III), Tm(III), Yb(II), Yb(III), or Lu(III), preferably Ce(lll) or Gd(III). In various embodiments the lanthanide cation is of oxidation stage 3+ and three coordinating gallium containing compound counter anions according to formula (1-1) are part of the coordination compound.

Preferably the three gallium containing compound anions are identical to each other, more preferably the rings A, and B are identical to each other. In various other embodiments the one lanthanide cation is of oxidation stage 3+ and there are two coordinating gallium containing compound counter anions according to formula (1-1) present and there is a third singly electrically negatively charged auxiliary ligand present, which is not a gallium containing compound.

Preferably the two gallium containing compound anions are identical, more preferably the rings A, and B are identical and preferably the third singly electrically negatively charged ligand being not a gallium containing compound is identical or a substituted derivative from any of the rings A, or B present in any of the two gallium containing compounds.

Various embodiments use lithium, cerium, and/or gadolinium coordination compounds selected from formula C1 to C15:

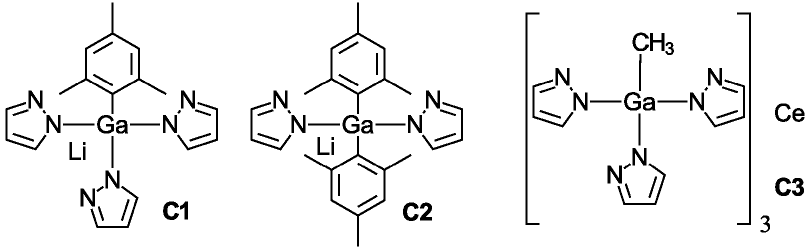

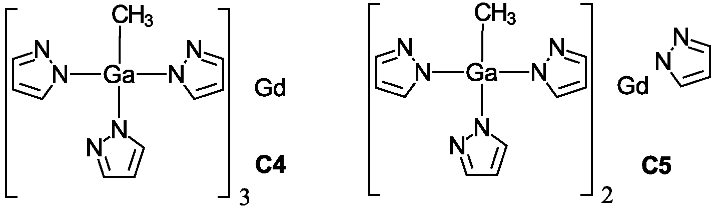

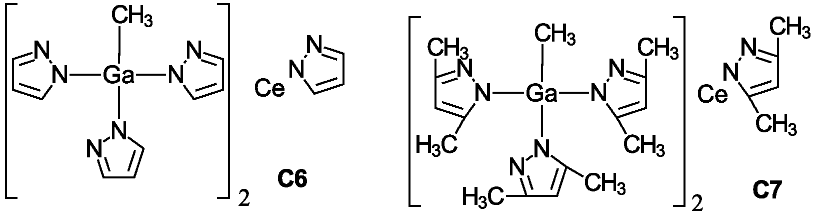

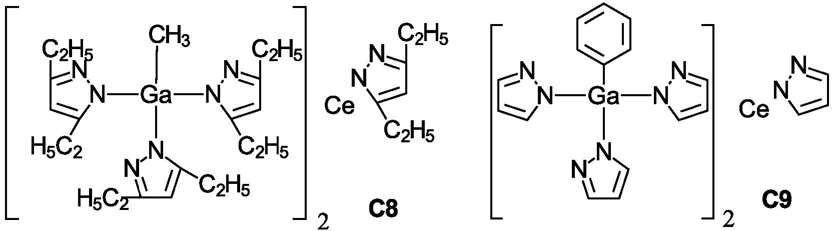

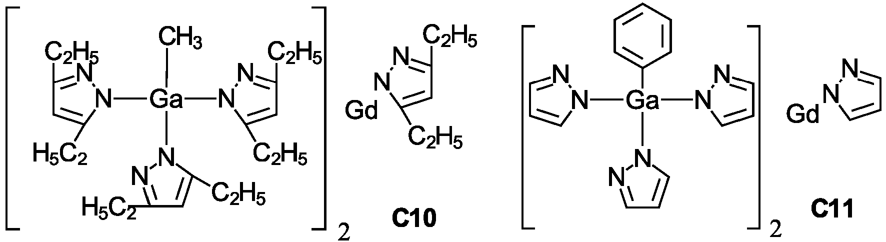

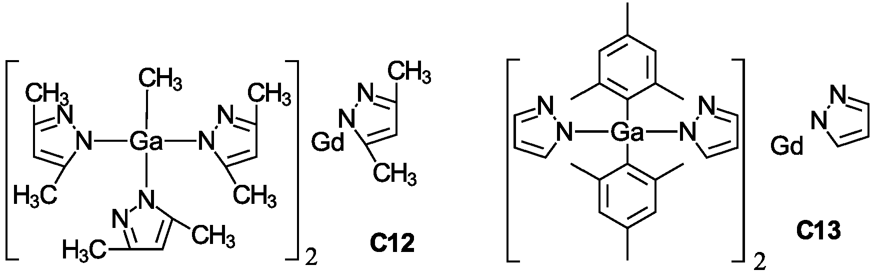

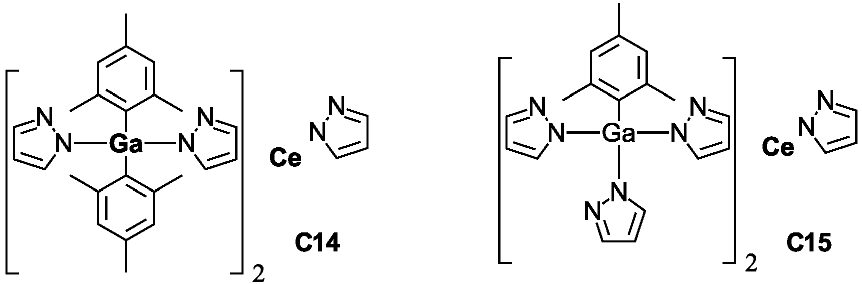

All those embodiments C1 to C15 use identical substituted or non-substituted pyrazoly heterocyclic, heteroaryl rings as part of the gallium containing compound. Any substitution on the pyrazolyl is symmetrically implemented in 3 and 5 position and uses small alkyl fragments, specifically methyl or ethyl. For the sterically less demanding non-substituted pyrazolys shown in C3 and C4 three identical gallium containing compounds are part of the metal organic coordination compound and no auxiliary ligand is present. In case of C5 to C15 two identical gallium containing compound type anions are present and there is a single third anion, the latter being identical to the heteroaryl ring present as part of the gallium containing compound anion, leading to specifically stable coordination compounds.

In preferred embodiments, the layer comprising the metal-organic coordination compound comprising the gallium containing compound anion according to the invention is deposited from a gas phase, preferably using an evaporation and/or sublimation and/or carrier gas process or by deposition from solution. Thermal sublimation and/or evaporation are the standard processes used in industrial consumer display production processes and given the high sublimation yield of the materials according to the invention, fabricating organic electroluminescent devices, in particular for OLED consumer displays, is readily possible using those processes. Alternatively, the coordination compound applied in the organic electronic device is deposited from solution, which may offer advantages in terms of throughput or production cost.

### Brief Description of the Drawings

In the drawings, like reference characters generally refer to the same parts throughout the different views. The drawings are not necessarily to scale, emphasis is instead generally being placed upon illustrating the principles of the invention. In the following description, various aspects of the invention are described with reference to the following drawings, in which:
**FIG. 1** exemplifies side groups that can be present in metal-organic coordination compounds according to the invention.
**FIG. 2** exemplifies organic gallium containing compound ligands that can be present in metal-organic coordination compounds according to the invention.
**FIG. 3** exemplifies metal-organic coordination compounds according to the invention.
**FIG. 4, FIG. 5** and **FIG. 6** illustrate schematic cross sections of electroluminescent devices according to various aspects.
**FIG. 7** depicts the photoluminescence spectrum of a metal-organic complex than can be used in examples according to the invention.
**FIG. 8** to **FIG. 12** depict various device characteristics of electroluminescent devices according to various embodiments of this invention as well as comparative examples.

### Detailed Description

The following detailed description refers to the accompanying drawings that show, by way of illustration, specific details and aspects in which the invention can be practiced.

The word "exemplary" is used herein to mean "serving as an example, instance, or illustration". Any aspect or design described herein as "exemplary" is not necessarily to be construed as preferred or advantageous over other aspects or designs.

Various embodiments relate to metal-organic compounds coordinated by one or more anions with the anions comprising a gallium metal covalently linked to four atoms or organyl groups, respectively.

In this description, a coordination compound is taken to mean a compound where the central metal, for example a lanthanide, is coordinated without a direct metal carbon bond. The terms complex, metal-organic compound, and coordination compound will be used interchangeably. The positively charged metal is repeatedly referred to as "the cation" and it will have a positive oxidation stage.

The gallium anion by itself is thus not a coordination compound, because all metal organic bonds are of covalent nature. The gallium anion itself is repeatedly referred to as the "gallium containing compound" in line with its single negative electrical charge.

As used herein, "deuterium" refers to an isotope of hydrogen. Deuterated compounds can be readily prepared using methods known in the art.

It is to be understood that when a molecular fragment is described as being a substituent or otherwise attached to another moiety, its name can be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

The terms "halo," "halogen," and "halide" are used interchangeably and refer to fluorine, chlorine, bromine, and iodine.

In this description, the arylene is a divalent organic fragment that is derived from an aromatic or heteroaromatic hydrocarbon (arene or heteroarene) by removing two hydrogen atoms from the aromatic or heteroaromatic hydrocarbon, preferably from different carbon and/or hetero atoms. One example is a (hetero) aromatic hydrocarbon that has had hydrogen atoms removed from two, preferably adjacent, hydrogen-bearing atoms (in case of aromatic hydrocarbon two carbon atoms, in case of heteroaromatic hydrocarbons two atoms selected from carbon and heteroatoms). An aromatic hydrocarbon or arene (or sometimes aryl hydrocarbon) is a cyclic hydrocarbon comprising only sp²-hybridized carbon atoms, leading to a delocalized π-system. An alkylene is a divalent organic fragment that is derived from an alkyl group by removing one additional substituent.

The term "alkyl" refers to and includes both straight and branched alkyl chain radicals and can furthermore also include cycloalkyl radicals. Preferred alkyl groups are those containing from one to fifteen, preferably one to ten, more preferably one to five carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group is optionally substituted, e.g., by halogen, preferably fluorine, or cycloalkyls.

The term "cycloalkyl radical" refers to and includes monocyclic, polycyclic, and spiro alkyl radicals. Preferred cycloalkyl groups are those containing 3 to 12, preferably 3 to 8 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group is optionally substituted, e.g., by halogen, deuterium, alkyl or heteroalkyl.

The terms "heteroalkyl" or "heterocycloalkyl" refer to an alkyl or a cycloalkyl radical, respectively, having at least one carbon atom replaced by a heteroatom. Preferably the at least one heteroatom is selected from O, S, N, P, B, and Si, more preferably O, or N. Preferably 1 to 5, more preferably 1 to 3, most preferably 1 or 2 heteroatoms are present in the radical. The radical can be covalently linked with the remainder of the molecule via a carbon or heteroatom (e.g., N). Additionally, the heteroalkyl or heterocycloalkyl group is optionally substituted as indicated for alkyl and cycloalkyl.

The term "alkenyl" refers to and includes both straight and branched chain alkene radicals. Alkenyl groups are essentially alkyl groups with more than one carbon atom that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one, preferably 1 to 5, more preferably 1 to 3, most preferably 1 or 2 carbon atoms replaced by a heteroatom. Preferably, the at least one heteroatom is selected from O, S, N, P, B, and Si, more preferably O, S, or N. Preferred alkenyl/cycloalkenyl/heteroalkenyl groups are those containing two/three/one to fifteen carbon atoms. Additionally, the alkenyl, cycloalkenyl, or heteroalkenyl group is optionally substituted, as indicated above.

The terms "aralkyl" or "arylalkyl" are used interchangeably and refer to an alkyl group that is substituted with an aryl group. Additionally, the aralkyl group is optionally substituted, as indicated for alkyl and aryl.

The term "heterocyclic group" refers to and includes aromatic and non-aromatic cyclic radicals containing at least one, preferably 1 to 5, more preferably 1 to 3 heteroatoms. Preferably the at least one heteroatom is selected from O, S, N, P, B, and Si, more preferably O, S, or N. Hetero-aromatic cyclic radicals can be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be optionally substituted, e.g., by halogen, deuterium, alkyl or aryl. The heterocyclic group can be covalently linked with the remainder of the molecule via carbon and/or heteroatoms, preferably one carbon or nitrogen atom. The heterocyclic group can as well be linked with two carbon and/or heteroatoms with the remainder of the molecule.

The term "aryl" refers to and includes both single-ring aromatic hydrocarbon groups and polycyclic aromatic ring systems. The polycyclic rings can have two or more rings in which two carbons are common to two adjoining rings (the rings are "fused") or wherein one carbon is common to two adjoining rings (e.g., biphenyl) wherein at least one of the rings is an aromatic hydrocarbon group, e.g., the other rings can be cycloalkyls, cycloalkenyls, aryl, heterocycles, and/or heteroaryls. Preferred aryl groups are those containing three to eight aromatic carbon atoms. Especially preferred is an aryl group having six carbons. Suitable aryl groups include phenyl, and radialene. Most preferred is phenyl that can be substituted by non-aromatic groups. Additionally, the aryl group is optionally substituted, e.g., by halogen, alkyl, heteroalkyl, or deuterium. The aryl group is connected to the remainder of the ligand via one or two carbon atoms.

The term "heteroaryl" refers to and includes both single-ring aromatic groups and polycyclic aromatic ring systems that include at least one heteroatom. The heteroatoms include, but are not limited to and are preferably selected from O, S, N, P, B, and Si. In many instances, O, S, or N are the preferred heteroatoms. Hetero-single ring aromatic systems are preferably single rings with 5 or 6 ring atoms, and the ring can have from one to five/six, preferably 1 to 3 heteroatoms. The hetero-polycyclic ring systems can have two or more rings in which two atoms are common to two adjoining rings (the rings are "fused") or wherein one carbon is common to two adjoining rings (e.g., bipyridine) wherein at least one of the rings is a heteroaryl, e.g., the other rings can be cycloalkyls, cycloalkenyls. The hetero-polycyclic aromatic ring systems can have from 1 to 5, preferably 1 to 3 heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyrrole, pyrazole, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably 1,3,4-Oxadiazole, furan, thiophene, 1,2,4-triazole, 1,2,3-triazole, and pyrazole groups, from which one hydrogen atom has been removed from a hydrogen-bearing carbon or heteroatom to form the covalent link to the remainder of the molecule. The heteroaryl group with two hydrogens removed can as well be linked with two carbon and/or heteroatoms with the remainder of the molecules, in which case the heteroaryl group can be part of a larger cyclic group. Additionally, the heteroaryl group is optionally substituted, e.g., by halogen, deuterium, alkyl or aryl.

Generally, aryl and heteroaryl groups with triplet level >2.5 eV or more preferably >2.6 eV or most preferably > 2.7 eV such as the groups derived from benzene, furan, dibenzofuran, dibenzoselenophene, carbazole, imidazole, pyridine, pyrazine, pyrimidine, triazine, and the respective aza-analogs of each thereof are of particular interest. There are many possible ways to probe the triplet energy level of an organic molecule. A simple way is to use suitable quantum mechanical calculations. A more experimental way takes the onset of the phosphorescence spectrum, which is usually detected using gated spectroscopy, as pioneered by Romanovskii et al. "Phosphorescence of π-conjugated oligomers and polymers." Physical Review Letters 84.5 (2000): 1027. In combination with high triplet energy, generally preference is given to benzene or low polarizable, hard heteroaryl groups, such as 1 ,3,4-Oxadiazole, furan, thiophene, 1,2,4-triazole, 1,2,3-triazole, and pyrazole carbazole, dibenzofuran, and benzofuran groups.

The alkyl, cycloalkyl, heteroalkyl, heterocycloalkyl, alkenyl, cycloalkenyl, heteroalkenyl, alkynyl, aralkyl, heterocyclic group, aryl, and heteroaryl groups or residues, as used herein, are independently unsubstituted, or independently substituted, with one or more (general) substituents, preferably the substituents mentioned herein.

Preferably, substituents as mentioned in this description, embodiments or claims are defined as follows: Preferably, (general) substituents are selected from the group consisting of deuterium, halogen, preferably with the exception of fluorine, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, and combinations thereof with the number of carbon atoms and heteroatoms as defined above or below for the respective term. Furthermore, one or two substituents can be selected from polymer chains which can be covalently linked with the remainder of the molecule by a suitable organic spacer. Therefore, the cyclic organic ligand can be covalently linked with a polymer chain or a polymer backbone.

Preferred general substituents are selected from the group consisting of deuterium, alkyl, cycloalkyl, heteroalkyl, alkoxy, aryloxy, amino, silyl, alkenyl, cycloalkenyl, heteroalkenyl, aryl, heteroaryl, nitrile, isonitrile, sulfanyl, and combinations thereof with the number of carbon atoms and heteroatoms as defined above for the respective term.

In yet other instances, the more preferred general substituents are selected from the group consisting of deuterium, alkyl, cycloalkyl, aryl, heteroaryl, and combinations thereof with the number of carbon atoms and heteroatoms as defined above for the respective term.

The terms "substituted" and "substitution" refer to a substituent other than H that is bonded to the relevant position, e.g., a carbon or nitrogen. For example, when R represents monosubstitution, then one R must be other than H (i.e., a substitution). Similarly, when R represents di-substitution, then two of R must be other than H. Similarly, when R represents no substitution, R, for example, can be a hydrogen for available valencies of straight or branched chain or ring atoms, as in carbon atoms for benzene and the nitrogen atom in pyrrole, or simply represents nothing for ring atoms with fully filled valencies, e.g., the nitrogen atom in pyridine. The maximum number of substitutions possible in a straight or branched chain or ring structure will depend on the total number of available valencies in the ring atoms or number of hydrogen atoms that can be replaced. All residues and substituents are selected in a way that a chemically stable and accessible chemical group results.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include thirty to forty atoms that are not hydrogen or deuterium, or those that include up to 30 atoms that are not hydrogen or deuterium counted for all substituents of a given molecule, or for the respective molecule in total. In various embodiments, a combination of substituent groups will include up to twenty atoms that are not hydrogen or deuterium, counted for all substituents of a given molecule.

In some instances, a pair of adjacent residues can be optionally joined (i.e., covalently linked with each other) or fused into a ring. The preferred ring formed therewith is a five-, six-, or seven-membered carbocyclic or heterocyclic ring, including both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, or 2,3-positions in a phenyl, or 1,2-positions in a piperidine, as long as they can form a stable fused ring system. In some instances, a pair of non-adjacent substituents can be optionally joined usually by an, at least partial, alkane or heteroalkene chain of atoms, thereby forming another macrocyclic ring system as part of the macrocyclic ring present as part of the coordination compound. In some instances, a pair of substituents present on the same carbon atom can be optionally joined, i.e., into an aryl or heteroaryl group, thus, forming a spiro linkage on said particular carbon atom.

In this description, embodiments and claims the term organyl refers to any chemically stable organic arrangement of atoms where one or more hydrogen atom has been removed such as to use those free vacancies to covalently link the organic group with another molecular entity. Thus, the term organyl preferably encompasses the majority of the above defined organic groups and is preferably selected from the group consisting of, alkyl, cycloalkyl, heteroalkyl, alkoxy, aryloxy, alkenyl, cycloalkenyl, heteroalkenyl, aryl, heteroaryl, nitrile, isonitrile, and combinations thereof with the number of carbon atoms and heteroatoms as defined above for the respective term. The term organyl shall especially as well encompass sufficiently chemically stable negatively charged species, such as anions, or anionic side groups.

In this description, an electroluminescent coordination compound is any material that is able to emit light upon electrical excitation, resulting from recombination of electrons and holes. It shall be irrelevant in this context whether the recombination of the electrons and holes takes place directly on the electroluminescent compound or first an excitation is formed on a different compound and subsequently transferred to the electroluminescent compound. Further, it shall be irrelevant in this context whether the light emitted is visible for the human eye or not. Especially, compounds emitting infrared and near ultra-violet emission shall be explicitly included. Further, it shall be irrelevant in this context whether the emitted light stems from an intrametallic, intraligand or charge-transfer transition between the ligand and a metal.

In the OLED community, the emission is usually classified as fluorescence if it originates from an optically allowed (spin-conserving) transition and decays within a few nanoseconds, such as the transition from the first excited singlet state to the singlet ground state, or, as phosphorescence if the emission originates from a spin-forbidden transition and decays with a few micro-milliseconds, such as from the first excited triplet state to the singlet ground state. The gallium containing compound anions according to the invention can be specifically useful to form stable metal-organic coordination compounds with lanthanide metal cations, which offers an elegant opportunity to design Cerium(III) deep blue emitting electroluminescent emitters, for example for OLED applications. The emission from the first electronically excited Ce(lll) results in an optically allowed spin-conserving d-f transition, which has a rather long excited state lifetime of around 35 ns, which is significantly longer as observed for typical fluorescent emitters. Thus, it clearly is neither fluorescent, nor phosphorescent in the typical context used in OLED community. It should correctly be referred to as emission from an intrametallic transition.

All embodiments of the invention concern electroluminescent devices that contain a metal-organic coordination compound, wherein the coordination compound comprises a gallium containing compound anion having at least two heterocyclic, preferably aromatic, rings, being described by the generical formula (1-1): 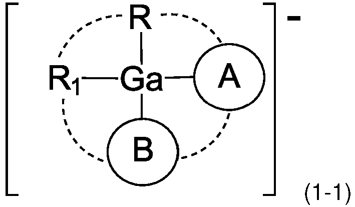 with definitions of A, B, R, R₁ and the broken lines as above. Formula (1-1) generates metal organic compounds comprising gallium in oxidation stage +3 which is covalently linked to at least two heterocyclic rings A, and B and to two hydrogens or substitutions thereof, R and R₁. The four covalent bonds lead to the formation of an overall singly negatively charged organic fragment, i.e. an anion, which be referred to as "gallium containing compound".

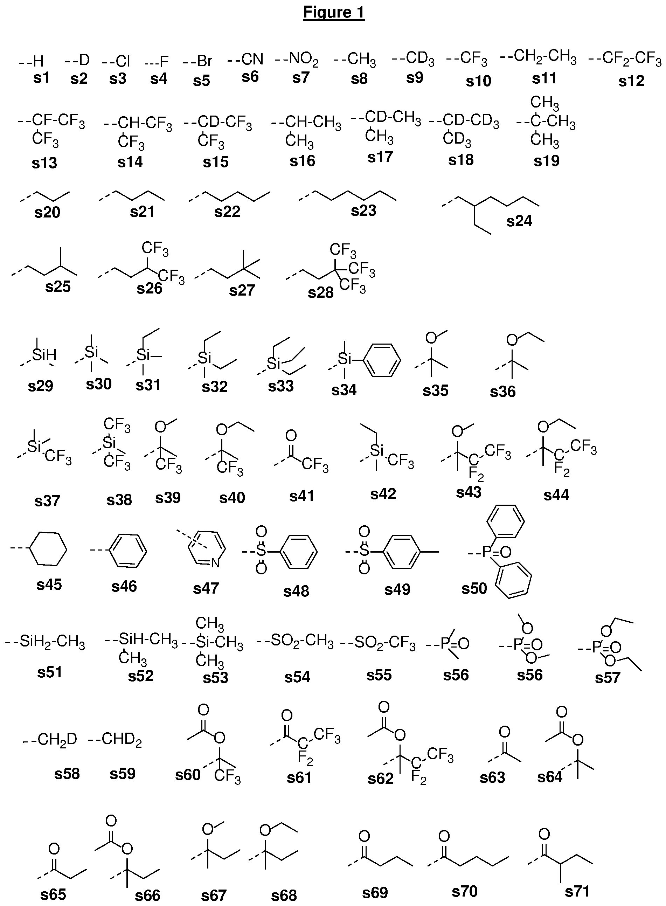

In general, substituents R and R₁ can each individually be any chemical fragment that can be covalently attached in accordance with formula (1-1). Within the scope of the invention R and R₁ can as well be combined into a single organic ligand forming two covalent chemical bonds with the central gallium metal cation. In various preferred examples R and R₁ are not covalently linked with each other but instead represent single atoms or organyl groups. In various embodiments R and/or R₁ will be hydrogen or deuterium. In preferred embodiments R and/or R₁ will be an organyl group. A wide range of substitutions can be envisioned by those skilled in the art and are in the scope of the invention. Without limiting this general scope, some examples of individual charge neutral substituents are s3 to s71 illustrated in FIG. 1, whereby a dashed line indicates the preferred covalent link of the shown molecular fragment to the central gallium cation according to formula (1-1). Those fragments are meant as illustration and many more side groups can be chosen, depending on the final application within the electroluminescent device according to the invention. For example, linear or branched alkane side chains can be chosen if a good solubility in non-polar solvents is needed. Examples are given as S8 to S28 in Fig. 1. Such substituents can as well suppress intermolecular interactions and generally improve the film formation, for example after processing through a gas transfer process. Generally preferable for the design of electroluminescent devices are organic materials with high thermal stability, for example suitable for evaporation or sublimation. In this case, preference is given to small and light weight substituents, i.e organyl fragments with individually less than 20 atoms and or individually a molecular weight of less than 100g/mol. Similarly, halogenated, particularly fluorinated, side groups, such as depicted in S11 to S15 in Fig1 can improve volatility and/or stability of the coordination compound. In case the intended application of the coordination compound of the invention is light generation within the electroluminescent device, the ligand preferably can be chosen such that the excitation of the coordination compound is confined to the central metal cation of the coordination compound according to the invention, which can specifically be an emissive lanthanide, such as Eu(ll) or Ce(III), or Er(III). In this way, a light-generating intrametallic transition with highest efficiency is obtained. In this particular situation, preferred substituents are side groups that do not easily polarize and that have a sufficiently high lowest triplet energy. Low polarizability is ensured for aliphatic or heteroaliphatic substituents or using small aryl- or heteroaryl systems with less than eight conjugated atoms or heteroatoms. The term "sufficiently high triplet energy" obviously depends on the emission color of the complex. For example, if the intended emission color is in the near infrared regime, for example by using Er3+ as central lanthanide, side groups comprising of extended aryl, or heteroaryl organyl groups, such as phenanthroline may still offer sufficiently high triplet level to ensure confinement of the excitation on the metal cation. On the other hand, if the coordination compound is intended to emit in the visible and in particular in the deep blue spectral region, for example realized by using Ce3+ as central metal, then side groups with a triplet energy >2.5 eV, or preferably >2.7 eV should be used. Sufficiently high triplet energy >2.7eV is generally observed for organyl groups comprising of aliphatic or heteroaliphatic fragments or for fragments comprising only small aryl- or heteroaryl systems with less than 8 conjugated atoms or heteroatoms, which thus should preferably be employed substituents if a deep blue electroluminescent emitter is the intended use of the coordination compound according to the invention. Examples of suitable side groups with respect to their triplet energy level are s2 to s71 illustrated in Fig. 1. It is understood that the small selection of organyl groups depicted in Fig. 1 serves as example only and do not constituent a preferred selection. Many more substituents can be envisioned by those skilled in the art. For example, the given examples S8 to S72 can be further substituted by replacing a suitable hydrogen or deuterium with an organyl group or a different atom. For example, three hydrogens of the phenyl substituent depicted as S46 can be substituted by methyl groups (S8) such that the substituent is a mesityl, which may be preferred for some specific applications.

The gallium metal of the anion according to the invention is covalently linked to at least two heterocyclic rings, labeled A, and B in formula (1-1). The rings can each individually generally be covalently linked through any position with the central gallium. According to the invention, the rings contain at least one heteroatom. This one or more heteroatom can be any atom that allows the formation of a stable cyclic organic ring. Without limiting the general scope of the invention, preference is given to O, N, and S, or combinations thereof, and more preference is given to O, and N and combinations thereof. In preferred situations, the covalent bond proceeds through a carbon or nitrogen ring atom. In the latter case, preferably there is one more heteroatom present within the heterocyclic, which can coordinate towards the central metal cation, in other words, the heterocyclic ring comprises two or more heteroatoms. According to the definitions above, within this disclosure, heterocyclic encompasses the subgroup of heteroaryl rings, i.e. heterocyclic rings with aromatic electron configuration, which in various embodiments can be preferred. Aromaticity is given for 2, 6, 10, aso π electrons. Without limiting the scope of the invention, and in particular for applications of the anion according to the invention as deep blue electroluminescent emitter, heteroaryl groups A, and/or B with six π electrons in combination with 5 or 6 ring atoms are generally preferred. Here, larger π systems with ten or more π electrons tend towards insufficiently low triplet energies. Without limiting the general scope of the invention, preferred heteroaryl groups can be selected from imidazoly-2-yl, imidazole-4-yl, pyrazolyl, 1,2,3-triazolyl, 1,2,4-triatolyl, thiazolyl, isothiazolyl, oxazolyl, 1,3,4-oxadiazole, and 1,2,4-thiadiazolyl.

For other applications the metal organic coordination compound can be a NIR infrared emitter and the electroluminescent device according to the invention can be NIR infrared emitting. In this situation the triplet energy requirements are much relaxed, and it can be preferable to configure the heterocyclic as aromatic heteroaryl rings with 10 or more aromatic pi electrons such that they can function as antenna to funnel excitation energy towards the central metal cation of the emitting coordination compound.

Whether or not any of the rings is specifically of heteroaryl type or not aromatic and a more general heterocyclic ring, in various preferred embodiments one or both of the rings are further substituted, that is, one or more hydrogens present at any of the rings are substituted by another atom or organyl group. Within the scope of the invention, suitable substituents can be any chemical fragment that can be covalently attached to the heterocyclic ring at any suitable position, thereby replacing a hydrogen atom. In various embodiments hydrogen(s) can be substituted by deuterium. In other embodiments one or more hydrogen will be substituted by an organyl group. A wide range of substitutions can be envisioned by those skilled in the art and are in the scope of the invention. Without limiting this general scope some examples of individual charge neutral substituents are s3 to s71 illustrated in **FIG. 1**, whereby a dashed line indicates the preferred covalent link of the shown molecular fragment to the heterocyclic ring A, and/or B. Those fragments are meant as illustration and many more side groups can be chosen, depending on the final application within the electroluminescent device according to the invention. For example, linear or branched alkane side chains can be chosen if a good solubility in non-polar solvents is needed. Examples are given as S8 to S28 in Fig. 1. Such substituents may as well suppress intermolecular interactions and generally improve the film formation, for example after processing through a gas transfer process. Generally preferable for the design of electroluminescent devices are organic materials with high thermal stability, for example suitable for evaporation or sublimation. In this case, preference is given to small and light weight substituents, i.e organyl fragments with individually less than 20 atoms and or individually a molecular weight of less than 100g/mol. Similarly, halogenated, particularly fluorinated, side groups, such as depicted in S11 to S15 in Fig. 1 may improve volatility and/or stability of the coordination compound. In case the intended application of the coordination compound of the invention is visible light generation within the electroluminescent device, the ligand preferably can be chosen such that the excitation of the coordination compound is confined to the central metal cation of the coordination compound according to the invention, which can specifically be an emissive lanthanide, such as Eu(ll) or Ce(III), or Eb(III). In this way, an intrametallic transition with highest efficiency is obtained. For such embodiments, preferred substituents are side groups that do not easily polarize and that have a sufficiently high triplet energy on its own and as well in combination with their parent heteroaryl fragment.

The examples depicted in Fig. 1 are limited to substituents forming a single covalent bond towards the heteroaryl ring. Within the scope of the invention are single organyl substituents forming two or more bonds towards the heteroaryl ring, implying that two or more hydrogens of the heteroaryl ring are substituted simultaneously. In this situation, the substituent can bond twice or more to the same ring atom, thereby forming for example a double or spiro linkage. It may as well be envisioned that the organyl substituent bonds to two or more different ring atoms simultaneously, leading to the formation of one or more cyclic rings in addition to the heteroaryl rings A, or B depicted in formula (1-1). Such additional, fused, ring can be of any type, including but not limited to aryl, heteroaryl, cycloalkyl or cycloheteroalkyl.

A substitution can as well simultaneously be present on ring A and ring B and thus link the two. Such a linker group can be any atom or organyl group that is able to form two stable covalent bonds along the broken line between the heterocyclic rings A, and B as indicated in formula (1-1). Similarly, the atomic or organyl substituent can link any of the heteroaryl rings with any of the organyl fragments R, or R₁. The described situations are qualitatively indicated by the broken lines in formula (1-1) and will be further exemplified below.

In preferred embodiments, one or more pyrazolyl heteroaryl ring is present as part of the gallium containing compound anion according to formula (1-1). The pyrazolyl can covalently bond to the gallium cation with one of its nitrogens, while the second nitrogen is forming a coordination bond with the central metal cation of the metal organic coordination compound according to the invention. Preferably, the gallium containing compound anion contains two or three pyrazolyl heteroaryl rings. Preferably, the pyrazolyl heteroaryl rings are substituted, for example in 3, 4, and/or 5 position. Here, this description follows the conventional numbering of the pyrazole ring atoms with the two neighboring nitrogens being labeled as position 1 and 2:

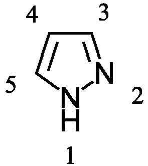

Without limiting the scope of the invention, some suitable substituents are given as s2 to S71 in Fig. 1. Preferred substituents are Deuterium or small alkane chains, such as methyl, ethyl, or propyl. In preferred substitution embodiments, the pyrazolyl heteroaryl ring is symmetrically substituted with respect to the two Nitrogens. In one such embodiment the pyrazolyl is only substituted in the 4 position, opposite both Nitrogens, for example using a terbutylgroup, S19 in Fig 1. In another, more preferred, embodiment the pyrazolyl is substituted in 3 and 5 position, with the 4 position being non-substituted. Preferably, the substituents in 3 and 5 position are identical, to engineer a symmetrical substitution around the two nitrogens of the pyrazolyl. Preferably, the two substitutions in 3 and 5 position are small alkyl chains, preferably methyl or ethyl:

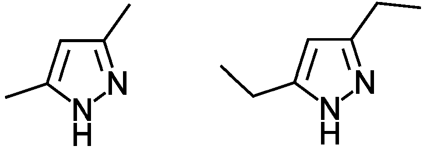

The heterocyclic rings A, and B of formula (1-1) are each individually covalently bond to the central gallium. Yet, indicated by the broken line, between those two fragments, there can be another chemical bond. This can be a direct covalent bond between two ring atoms of ring A, and B, respectively. More preferably the linkage proceeds through a formally biradical organyl linker group, which for example can be a single atom, such as an Oxygen or a Carbon. Even more preferably, the linking group contains more than one atom, for example, it can be an aryl fragment, such as a phenyl group:

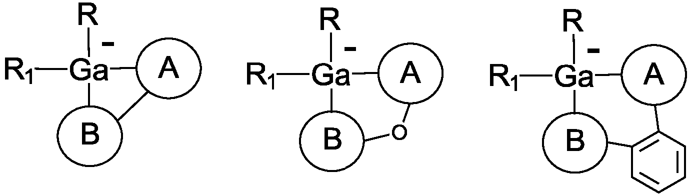

According to the invention the heterocyclic rings A, and B do contain at least one heteroatom each in the ring and as such can form a stable coordination bond towards a central metal cation. The two remaining covalent bonds of the gallium are saturated by R and R₁ being each individually either atoms or organyl groups. Those two organyl groups may or may not form any coordination bonds towards the central metal cation. In most embodiments it is sterically not possible that both substituents, if present, do coordinate the central metal cation in parallel to the two heterocyclic rings A, and B, and it is more likely that only one or none of the organyl fragments R and R₁ will coordinate the central metal cation. Therefore, R and R₁ can be chosen independently to each other and relatively freely depending on the intended use of the metal organic coordination compound according to the invention.

Of specific interest are coordinating gallium containing compound type anions according to formula (1-1) where three heterocyclic groups are coordinating towards the central metal cation; coordinating ligands, which are commonly referred to as "scorpionates". To engineer such a molecule, besides A, and B, R₁ in formula (1-1) will heterocyclic ring too, respectively. In case of three coordinating heterocycles, A, B, and R₁, they can each individually be chosen differently. Within the scope of the invention are further asymmetrical situations, where two or three of the coordinating heterocycles, A, B, and R₁ are identical to each other, but the identical rings are differently substituted. In a specific embodiment, two identical heterocyclic rings can be linked to each other, whilst the third identical heterocycle is not linked to the ligands fragment containing the other two heterocycles. All those asymmetrical gallium containing compounds are within the scope of the invention and they may indeed be relatively straightforward synthetically accessible given that the substitution starting from the GaH₄ gallium source proceeds step wise (compare synthetic section below), which allows for a wide range of non-symmetrical substitution patterns. To allow for high stability, generally preferred are organic molecules that do not form isomers, and/or disproportionates. For example, it can be envisioned that during elevated temperatures, a heteroleptic gallium containing compound may disproportionate into two homoleptic ones. To avoid such potentially undesirable situations, generally preferred are gallium containing compounds according to formula (1-1) with similar or identical organyl fragments. Specifically, preferred are gallium containing compounds according to formula (1-1) with identical heterocyclic rings A and B, and more preferably with identical substitution pattern on the two rings too. Translated to the situation of R₁ being a coordinating heterocyclic ring too, of specific interest are gallium containing compounds with A, and B, R₁ being identical to each other, both in their heterocyclic ring and in their substitution pattern, if any. Those specific derivatives of formula (1-1) are described by the generic formula (1-2): 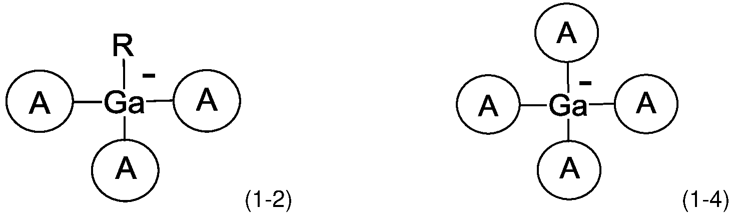 with A and R having the same meaning as above. Formula (1-2) describes symmetrical scorpionates, which may be well suited to coordinate a central metal cation. R can be hydrogen or any derivative as described above. Yet in one specific embodiment derived from formula (1-2) R can be an identical heterocyclic ring too, leading to an even more specific tetrakis version of formula (1-2), which is depicted as formula (1-4). Within the scope of this invention, there is no specific limit of the choice of the heterocyclic ring A of this more symmetrical molecules according to formula (1-2) as compared to the potentially asymmetrical molecules according to formula (1-1). In line with the description of above, preference is given to heteroaryl rings A and specific preference is given to A being a pyrazolyl fragment. Preferably, the latter is unsubstituted or symmetrically substituted in 3, and 5 position, preferably using a small alkyl chain such as methyl or ethyl.

The heterocyclic rings used in formula (1-2) may be well suited for coordinating a central cation, or may be otherwise specifically beneficial, for example to obtain high thermal stability. Depending on ring size or specific substitution pattern it may be that the design of gallium containing compounds with three such beneficial heterocyclic rings may not be preferrable, for example because in combination three such heterocycles' would be sterically too demanding to form a stable gallium containing compound anion according to formula (1-2). Given the stepwise build-up of the gallium containing compound it may still be possible to use the beneficial heterocycle and a preferred way to design the gallium containing compound according to the invention will that two identical heterocycles are used. Specifically interesting derivatives use twice hydrogen, or - preferably - two identical substitutions for the remaining covalently organyl groups R, and R₁. Those specific derivatives of formula (1-1) are described by the generic formula (1-3): 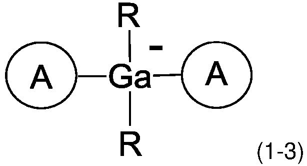 with A and R having the same meaning as above. Consistent with the above, R can be hydrogen, deuterium or - preferably- an organyl group. The latter can be chosen depending on the intended use of the coordination compound within the electroluminescent device. For light emitting coordination compounds general preference is given to R being a substituted or non-substituted aryl, such as mesityl, or R being a small alkyl chain such as methyl, or ethyl. In line with the description as given above, preference is given to aromatic, heteroarylic, rings A and specific preference is given to A being a pyrazolyl fragment. Preferably, the latter is unsubstituted or symmetrically substituted in 3, and 5 position, preferably using a small alkyl chain such as methyl or ethyl.

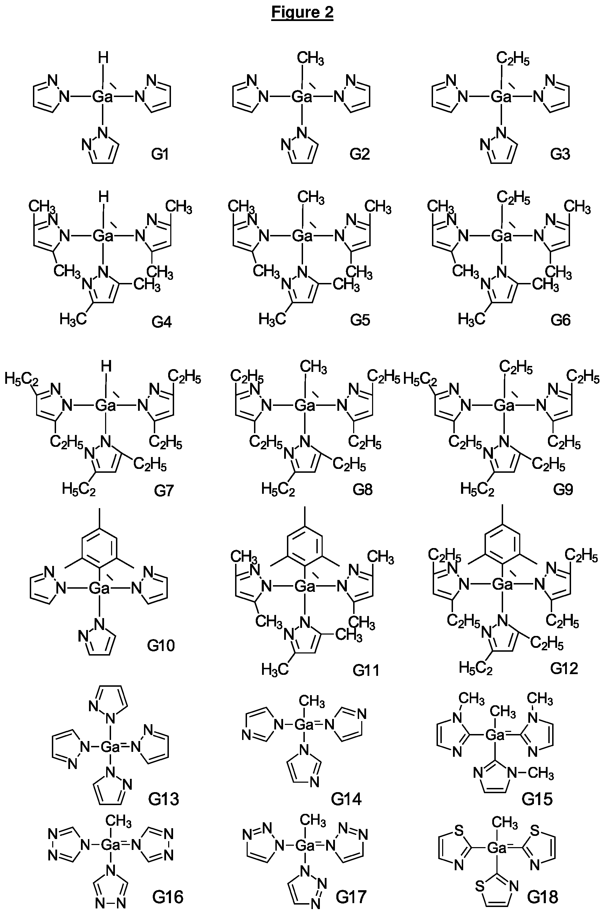

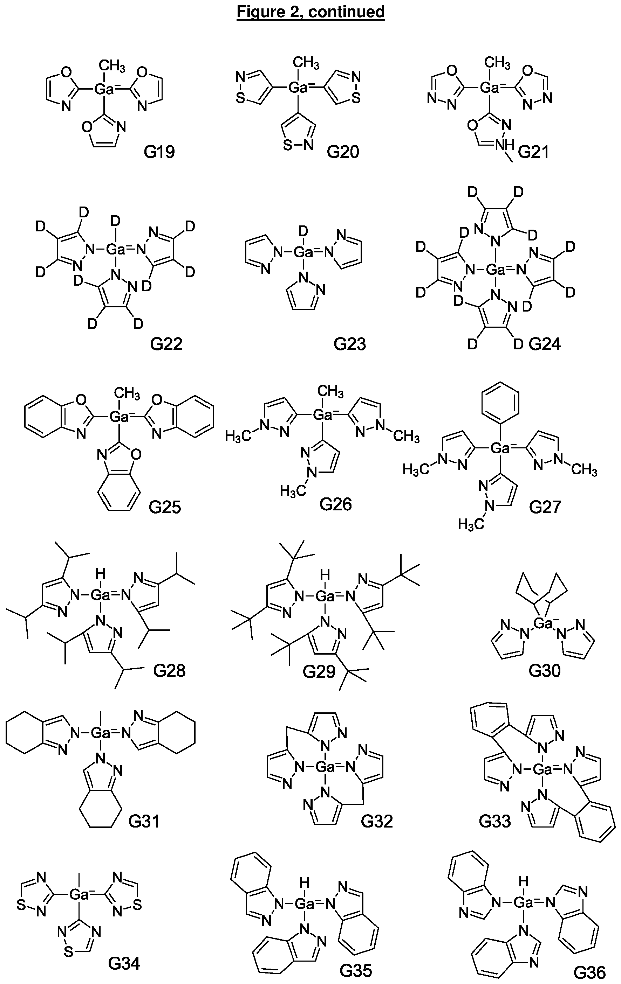

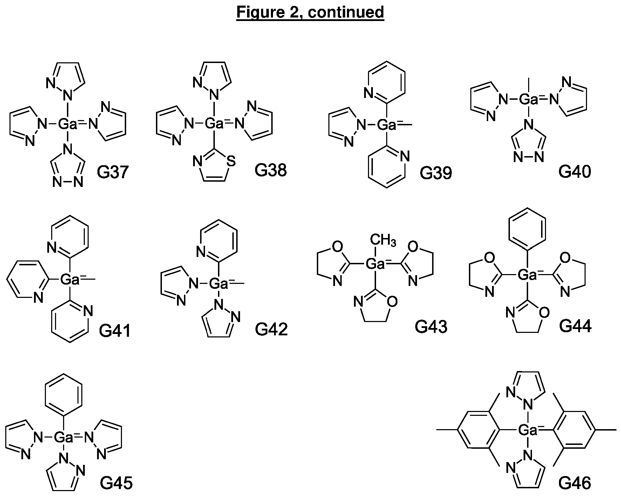

Without limiting the scope of the invention, G1 to G46 shown in **FIG. 2** further illustrate examples of gallium containing compound type ligands according to formula (1-1). The concrete compounds depicted serve for illustration purposes and shall help to show the scope of the invention. In this context, most of the possible substituents that can be present on certain carbon or heteroatoms have been omitted for clarity. They can nevertheless be present. All structures exemplified contain two identical heterocyclic rings (A, and B in formula (1-1)). Those two rings are in all cases additionally identical in their substitution pattern, if any is present. The majority of examples depicted in Fig. 2 exemplifies three identical heterocyclic rings with identical substitution pattern, according to formula (1-2). Exceptions are compounds G30, G39, G40, G42, and G46, with only two identical heterocyclic rings. G39, and G40 exemplify three heterocyclic rings that are not all identical to each other. In G46 the third and fourth substituent R and R₁ are both identical aryl organyl fragments, specifically multiple substituted aryl, more specifically mesityl. The compound is thus an example of formula (1-3) having two identical substituents R and R₁ and two identical heterocyclic rings A, and B. The majority of examples in Fig. 2 is generated from formula (1-2), i.e. three identical heterocyclic rings A, B, and R₁ are present. According to the invention, R can be hydrogen and this is exemplified in G1, G4, G7, G28, and G29. Hydrogen can be replaced by deuterium, which can offer superior stability, and which is exemplified in G22, and G23. In preferred examples R is a small alkyl chain such as methyl (G2, G5, G8, G14 to G21, aso) or ethyl (G3, G6, and G9). In various other embodiments, R is a cyclic group, such as an aryl group. Preferred are relatively small aryl groups such as shown as G27, G44, and G45. As discussed, any such substituent can be further substituted. In the case of R being phenyl, this is exemplified by G10 to G12, which use threefold substituted phenyl, specifically mesityl. Within the scope of the invention, R can as well be a heterocyclic substituent. In specific embodiments, described by formula (1-4), R is identical to A, and B, and identical to R₁. Examples of such highly symmetrical anions are G13 and G24, which are both based on pyrazolyl, 4 of which are covalently bound to the gallium. In other embodiments, R is a heterocycle but not identical to A, or B. Examples according to this situation are depicted as G37 and G38 in Fig. 2. According to the invention and indicated by a broken line in formula (1-1) a substituent, R, can be covalently linked with the heterocyclic group A, and/or the other substituent R₁. The latter situation is depicted in G30. Here, two heterocyclic rings, specifically non-substituted pyrazolyls, are present. Substituent R and R₁ form a single branched alkane-diyl group that is twice covalently bond to the gallium. In other words, the two substituents R and R₁ are covalently linked with each other.

In the vast majority of examples depicted in Fig. 2, the heterocyclic rings, A, B, according to formula (1-1) are heteroaryl groups, i.e. they are aromatic. Exceptions exemplifying non-aromatic heterocyclic rings are G43 and G44. Most heteroaryl examples in Fig. 2 are based on pyrazolyl, specifically 1H-pyrazolyl and one of the two nitrogens present in the pyrazolyl is covalently binding towards the gallium. In examples G26 and G27 all heterocycles are still 1H-pyrazolyl, but the gallium is covalently bond by a ring carbon atom. Alternatively to pyrazolyl, examples G14 to G21, G25, G34, and G36 illustrate other heteroaryl rings. Those examples use aromatic rings based on the preferred heteroatoms sulfur (G20, G34, and G38), oxygen (G19, G21, and G25), and mostly nitrogen. Preferably two or three heteroatoms are present within each heterocyclic ring. If there is only one heteroatom present, the ring is preferably covalently bond to the gallium using a ring carbon atom, such that the single heteroatom can still coordinate the central metal cation. Examples of gallium containing compound anions based on heterocyclic rings with only one heteroatom in preferred covalent bond are G39 and G41 where pyridine is the heterocyclic group. In the majority of examples depicted in Fig. 2 two or three heteroatoms are present as part of the heterocyclic ring, one of which is nitrogen. The preferred heterocyclic ring is pyrazolyl, and most compounds in Fig. 2 are depicted accordingly. The pyrazolyl can be unsubstituted such as exemplified in G1, G2, G3, G10, G13, G23, G30, G37, G40, G42, G45, and G46. In various other embodiments, pyrazolyl is substituted once or more often at any carbon ring atom. For applications requiring high chemical stability, it may be beneficial to substitute hydrogen partly or completely by deuterium. For example, all possible hydrogens present at the pyrazole are replaced by deuterium in G22, and G24. In various preferred embodiments, the substitution is at the 3 and the 5 position and the substitute is identical in both instances. This preferred substitution pattern is exemplified using methyl (G4, G5, G6, G11) ethyl (G7, G8, G9, G12) isopropyl (G28) and tert-butyl (G29). In various embodiments a single substituent can as well twice covalently bond to the heterocyclic ring. If it links to different, preferably neighboring, ring atoms a double-cyclic organyl fragment forms, which can be in the form of a second ring. In G31 a butyl fragment is twice bond to pyrazolyl in neighboring 3 and 4 position thereby forming an additional cyclohexane unit that is fused onto the pyrazolyl. Similar, G35 exemplifies the situation of a benzene ring fused in 4 and 5 position to pyrazole. Finally, G32 and G33 illustrate the situation of the two heterocyclic rings being covalently linked with each other. The heterocyclic rings, A, and B, as well as the other two substituents R and R₁ in G32 and G33 are all pyrazolyl. In both compounds two pyrazolyls are covalently linked with each other via the carbon 5 position of the 1H-pyrazolyl using a linker group which is CH₂ for G32 and a benzene ring for G33. In effect, the gallium containing compound contains two identical organic fragments which are each twice covalently bonded to the gallium.

All electroluminescent devices of the invention contain a metal-organic coordination compound, wherein the coordination compound comprises a gallium containing compound anion described by the generical formula (1-1). As the metal-organic coordination compound according to the invention is charge-neutral and the at least one gallium containing compound anion is negatively charged and its intended use is coordination, there is at least one positively charged metal present, a cation. Organic cations such as ammonium are not within the scope of this invention. In various preferred embodiments the metal-organic coordination compound used in the electroluminescent device according to the invention contains one metal cation only. This second type of metal besides gallium can be any positively charged metallic element. Without limiting the general scope of the invention, the metal can for example be chosen from an alkali or alkali earth metal, form a lanthanide or actinide, or from a d-block metal. The organic gallium containing compound type ligand according to the invention is specifically well suited to form coordination bonds, therefore it may be specifically useful to form metal-organic coordination compounds using alkali metals, alkaline earth metals, actinides, and lanthanides. Of specific interest for electroluminescent devices are alkali, alkaline earth, and lanthanides. Various cations may be specifically useful to design functional organic layers within the electroluminescent device according to the invention. Without limiting the scope of the invention, for example alkali metal gallium containing compound can be used at the interface between a metal electrode and the organic layer and function as charge injection layer owning to their typically high dipole moment. Of particular interest for this application are the small alkali metals, specifically sodium and lithium. In other embodiments, the intended use may be charge transport and the metal-organic coordination compound according to the invention may be a host material. Without limiting the general scope of the invention electron transport functionality may for example be achieved using a suitable heteroaryl ring as part of the gallium containing compound anion according to formula (1-1). In one embodiment electron transport characteristics are achieved by using aryl, specifically benzyl, and/or substituted pyrazolyl rings as part of the gallium containing compound. In various other embodiments 3,5 substituted pyrazolyl is used, with preference in both substituents being ethyl. For charge transport, and specifically for electron transport, preference is given to compounds with low overall dipole moment to reduce polarization effects. This goal may for example be achieved by designing symmetrical compounds using an alkali earth metal, such as Mg, in combination with two, preferably identical, gallium containing compound anions according to formula (1-1). In various other embodiments, the intended use of the metal-organic coordination compound according to the invention is hole transport and the metal cation is a redox-active metal. Of interest are for example Ce(lll) complexes, which, during device operation, may undergo reversible oxidation towards Ce(IV) and allow for hole transport. In various other embodiments, the metal organic coordination compounds according to the invention are used as hole injection layers or as p-dopant (redox dopant) to facilitate hole transport or injection. Such materials may for example be used as thin interlayer between the anode and the adjacent organic layer, or they may be mixed into a hole transporting organic material, or they may be used as part of a charge generation layer, also known as pn-junction. Without limiting the general scope of the invention, of particular interest to design redox-active p-dopants are metal organic coordination compounds based on Ce(IV). In various other embodiments, the intended use of the metal-organic coordination compound according to the invention is light generation, in other words, the materials are used as organic emitters. There are many possibilities known to those skilled in the art of generating light using metal organic complexes. For example, d-metals, such as Ir(III) or Pt(ll) may be used to engineer a metal-to-ligand charge transfer transition of suitable wavelength. In other embodiments, and intraligand transition is used to emit light. The latter one may occur from the lowest triplet excited state of the ligand and this phosphorescence may be enhanced using a relatively heavy metal cation. In various embodiments, the intraligand transition is the lowest one of the metal-organic coordination compound, and of specific interest to design such emitters are inert heavy lanthanides such as Ln(III), Lu(III), and Gd(III). In various other embodiments the emission from the metal-organic coordination compound is substantially an intrametallic transition, that is, the optical transition is centered on the metal cation. Given the excellent coordination ability of the gallium containing compound anions according to the invention, of specific interest is the design of intrametallic emitters based on suitable lanthanides. In various embodiments, the intended use of the electroluminescent device according to the invention is near infrared light emission. In this situation, a coordination compound based in suitable lanthanides such as Er(III), Tm(III), Yb(III), Nd(III), and Ho(lll) can be used. In various other applications the intended use of the electroluminescent device according to the invention is visible light emission and red, green and blue emissive coordination compounds based on Eu(III), Tb(III), and Tm(lll) can be used, respectively. Of specific interest for OLED display applications are intrametallic d-f type lanthanide transitions, owning to their short excited state decay time, which allows to reach high light generation efficiencies even at high driving currents. In various preferred embodiments of this invention, electroluminescent emitters employing the intrametallic d-f transition of Yb(II), Eu(ll) and Ce(lll) are employed in the devices according to the invention. For their better ambient stability, more preference is given for Eu(ll) and Ce(III). Eu(II) offers a single peak emission spectrum but may show limited ambient stability, and it may be the preferred choice for various applications. Ce(lll) shows a less color pure double peak emission spectrum but generally very high ambient stability and it may be the preferred metal cation for the design of deep blue electroluminescent emitters.

The metal-organic coordination compound used in the electroluminescent devices according to the invention contains at least one gallium containing compound anion according to formula (1-1). The metal cation can be in various oxidation stages, that is it can be singly or multiply positively electrically charged. If the metal cation is a single electrically positively charged cation, for example an alkali metal, the metal organic coordination compound can contain exactly one gallium containing compound anion according to formula (1-1), so that the compound is charge neutral. If the metal cation is higher than +1 electrically charged, for example +2 or +3 or +4 than there may be more than one gallium containing compound type anion according to formula (1-1) present within the coordination compound. In various embodiments the oxidation stage of the central metal matches the number of gallium containing compound anions according to formula (1-1) such that a charge neutral coordination compound comprising only gallium containing compound anions and the central metal is formed. For example, the central metal can be a lanthanide in oxidation stage +3 and three - preferably identical - gallium containing compound anions according to formula (1-1) are present, which would yield a homoleptic complex. In various other embodiments heteroleptic complexes are formed with metal cation of oxidation stage higher than +1. It may be that different types of gallium containing compound anions are coordinated. In various other embodiments the coordination compound comprises gallium containing compound and non-gallium containing compound type anions. For example, a metal cation of oxidation stage +3 can comprise one gallium containing compound anion according to formula (1-1) and two additional anions that are not gallium containing compounds. The additional anions can be the same or different. In various other embodiments there is one gallium containing compound anion present and one additional anion, the latter being twofold electrically negatively charged. Of specific interest with respect to central metal cations of oxidation stage +3, such as various lanthanides, are heteroleptic compounds comprising two - preferably identical - gallium containing compound anions according to formula (1-1) and one further anion, that is not a gallium containing compound. The third anion, being not a gallium containing compound, can be any negatively charged chemically stable group or atom. In various embodiments, the third anion can be a halogen, such as iodide. In various other embodiments, the third anion can be a small organic or inorganic anion with less than 10 atoms, for example OH-. Without limiting the general scope of the invention, in various preferred embodiments, the third non-gallium containing compound singly negatively charged group is an organic anion that is derived from any of the heterocyclic rings A, or B being present as part of any of the gallium containing compounds present in the coordination compound. For example, one or more of the heterocyclic rings present in any of the gallium containing compound is a substituted imidazolyl group. In various embodiments, the third ligand can be a non-substituted imidazolate. In various other embodiments, the third ligand can be a substituted imidazolate and in specific embodiments its substitution pattern can be identical to the one used as part of the substituted imidazolyl ring of the gallium containing compound. Generally preferred within this disclosure are substituted or non-substituted pyrazolyl heterocyclic rings. Further preferred are identical rings with preferably identical substitution pattern within a single gallium containing compound anion. Further generally preferred are coordination compounds comprising only one type of gallium containing compound anion. With respect to the design of heteroleptic coordination compounds with central metal of oxidation stage +3, such as many lanthanides, preferred is the use of two identical gallium containing compound anions according to formula (1-1) that comprise identical pyrazolyl rings A, and B. If the pyrazolyls are substituted they each identically preferably are substituted in the 3- and 5-position with the same organyl fragment. The third anion being not a gallium containing compound is preferably derived from pyrazolyl too and is a substituted or non-substituted pyrazolate. Without limiting the general scope of the invention various possible organic anions that can be present as part of the coordination compound according to the invention are depicted as A1 to A5 below. A1 and A4 are non-substituted pyrazolate and triazolate. A2, A3, A5 are examples of symmetrically in 3,5 position substituted pyrazolate.

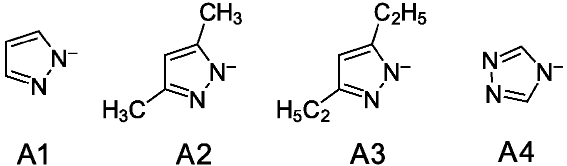

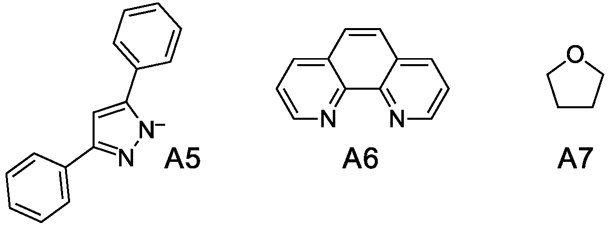

Besides anionic groups, the metal-organic coordination compound according to the invention can comprise additional charge neutral organic or non-organic groups. Of particular interest are organic coordinating ligands that help to fill the coordination sphere of the central metal cation, thereby creating a robust material suitable for the design of electroluminescent devices. In various embodiments, tetrahydrofuran or acetonitrile are part of the metal-organic coordination compound according to the invention. In various other embodiments, aromatic coordinating groups such as phenanthroline are present. Such larger groups can be specifically beneficial if the intended use of the metal-organic coordination compound is to transport charges such as electrons. In various other embodiments, the intended use is near infrared light emission and the charge neutral ligand is used to funnel excitation energy towards and intrametallic emission center. For intended use of the metal-organic coordination compound according to the invention as deep blue emitter, Ce(lll) can be the preferred metal cation and preferably no further charge neutral auxiliary ligand is present that is the compound comprises one or two gallium containing compound type anions and two or one further anions, not being gallium containing compounds.

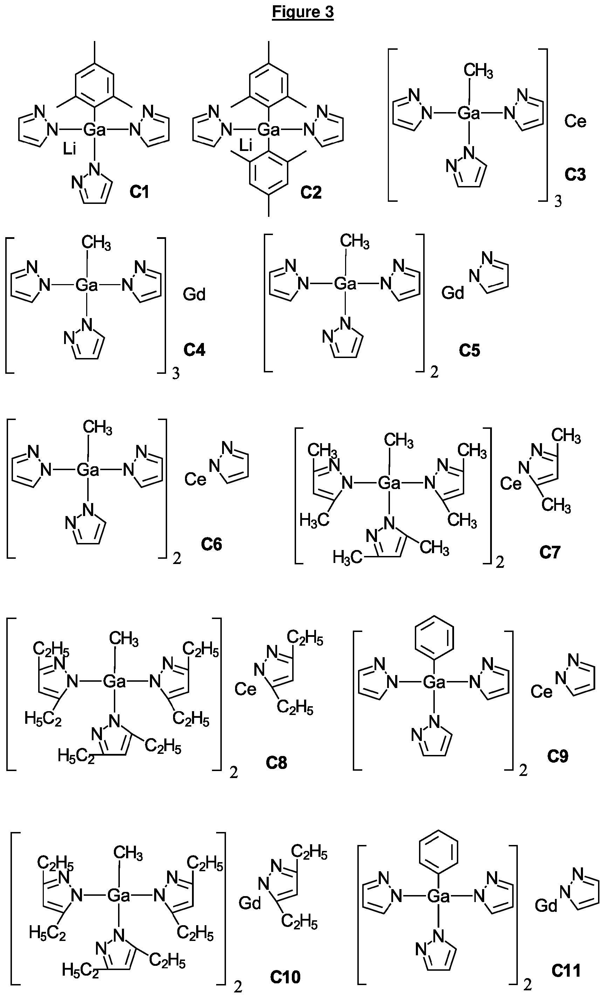

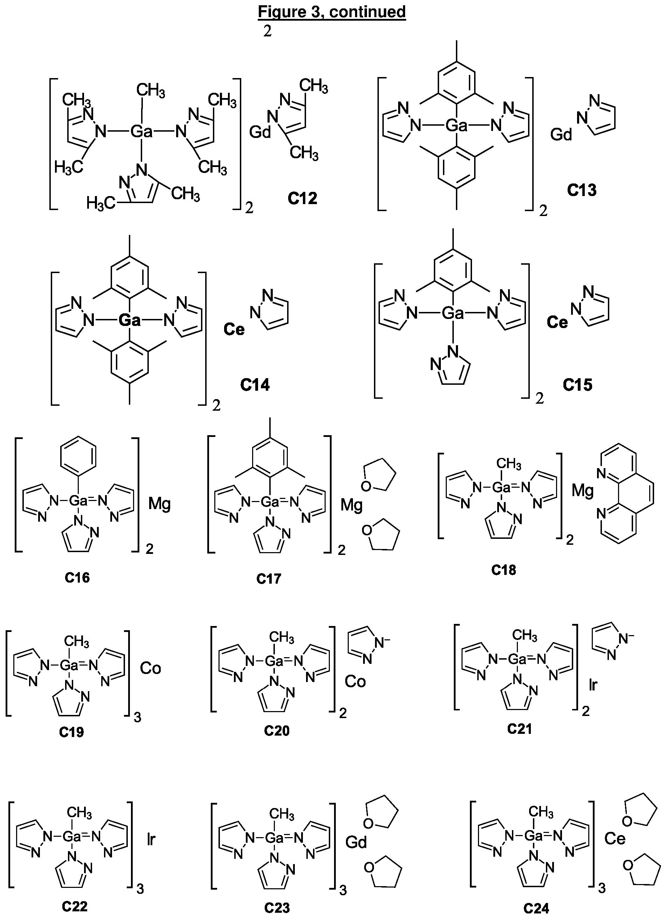

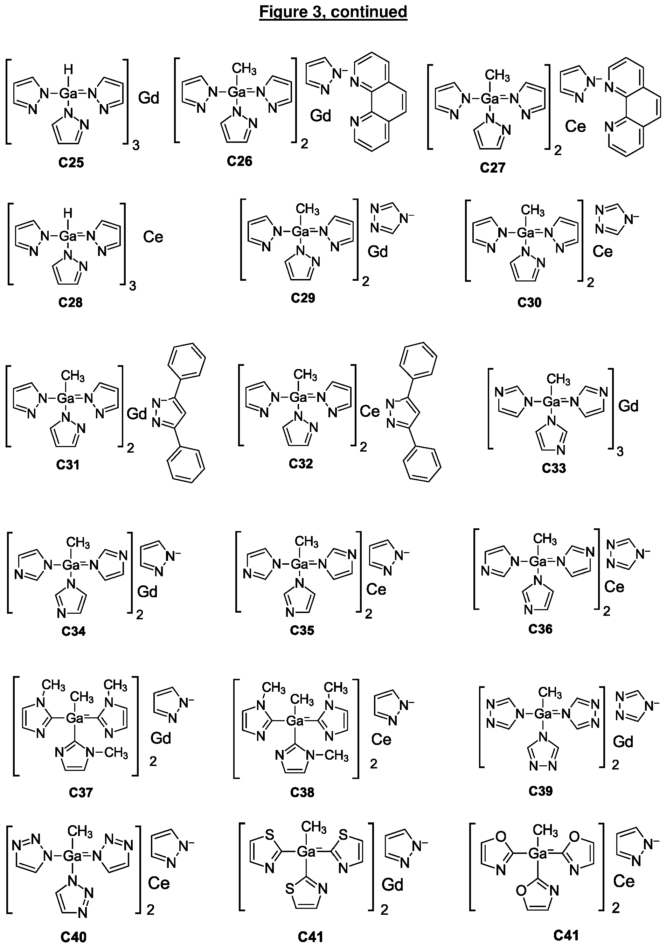

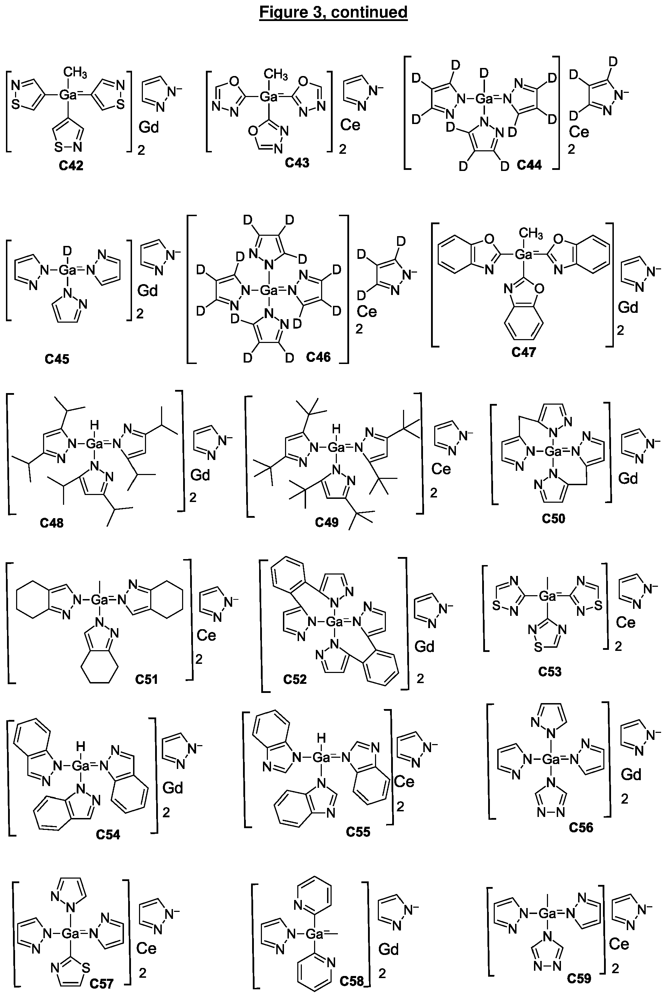

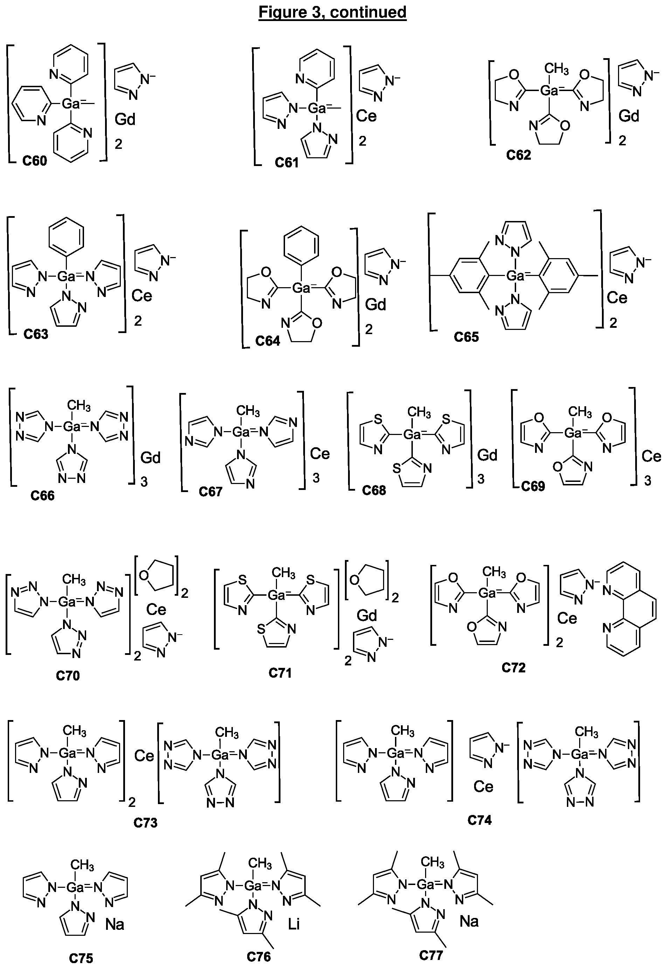

A very wide range of metal-organic coordination compounds can be used in the electroluminescent devices according to the invention. As outlined above, many combinations are possible by - independent- choice of the heterocyclic rings A, and B, various substitutions on those ring atoms, independent choice of the side groups R and R₁, various metal cations, different gallium containing compound anions for metal cations with oxidation stage higher than +1, use of charge neutral auxiliary ligands, and/or use of additional anions other than gallium containing compounds for cations with oxidation stage higher than +1. Therefore, the chemical scope of suitable materials is obviously very large and not all envisioned materials can be explicitly drawn here. To further illustrate the scope of invention selected examples C1 to C77 are depicted in **Fig. 3****.** It is understood that those are specific examples only which should not limit the wider combinatorial scope of the invention. For the examples depicted, the gallium containing compound type anions are mostly already described in Fig. 2 and are here combined with suitable metal cations, optional further anions, and optional further charge neutral auxiliary ligands.

Here oxidation stage +1 metal cations, specifically Li and Na in combination with one gallium containing compound anion are depicted in C1, C2, and C75 to C77. All other examples possess a metal cation of oxidation stage higher than +1. Alkali earth metal cation Mg(ll) is used in C16 to C18 in each case in combination with two identical gallium containing compound anions. Compounds C19 to C22 illustrate the use of d-metals, specifically Co(lll) and Ir(III). All other compounds shown in Fig. 3 use a lanthanide as central metal cation, specifically a lanthanide in oxidation stage 3+, and more specifically Gd(III) and Ce(III). All exemplified use at least two identical heterocyclic rings A, and B. In many examples even three identical heterocyclic rings are exemplified. In many examples the preferred heteroaryl ring, pyrazolyl is exemplified. If substitutions are used on pyrazolyl, they are shown in the preferred symmetrical arrangement, i.e. in 3 and 5 position using an identical substitute. For +3 oxidation stage central metal cations three gallium containing compound type anions according to formula (1-1) can be present and preferably those three gallium containing compound type anions are identical in their chemical structure, including possible substitution patterns on the heterocyclic rings. Corresponding homoleptic examples are C3, C4, C19, C22 to C25, C28, C33, and C66 to C69 in Fig. 3. The other examples illustrate the use of different types of anions in one given metal-organic coordination compound, of which at least one is a gallium containing compound according to formula (1-1). Specifically, the vast majority of those other examples illustrate using 2 identical gallium containing compound type anions in combination with one further anion, not being a gallium containing compound type. Exceptions are C73 using three gallium containing compound anions of two different types and C74 which uses two gallium containing compound anions of two different types in combination with one further anion not being a gallium containing compound. Generally, the further anion is preferably an organic anionic ligand derived from any of the heterocyclic rings present in any of the gallium containing compounds. The preferred heterocyclic group is pyrazolyl and examples with two pyrazolyl type gallium containing compound anions in combination with a pyrazolate further anion are depicted as C5 to C15, C20, C21, C26, C27, C31, C32, C44 to C52, and so on. In many of those cases the pyrazolate is exactly identical to the ring heterocyclic groups, i.e. including its specific substitution pattern. Yet in various examples the substitutions are different for example in C45 and C48 the heterocyclic rings are once or twice substituted, whilst the further pyrazolate anion is not. Similarly, in C31 and C32 the gallium containing compound pyrazolyl's are non-substituted, whilst the further pyrazolate anion is substituted twice. Various examples depicted in Fig. 3 demonstrate the incorporation of auxiliary charge neutral coordinating ligands as part of the metal-organic coordination compound according to the invention. For example, in C17, C23, and C24 two tetrahydrofuran ligands are part of the coordination compound. Similarly, in C18, C26, C27, and C72 phenanthroline is exemplified as auxiliary heteroaryl ligand. C70 to C72 exemplify the situation of one or two auxiliary ligands being present in a heteroleptic complex that is a complex that comprises two gallium containing compound type anions and one further non-gallium containing compound type anion.

The combination of chemical robustness with ability of forming very stable coordination compounds for example with cerium make metal-organic coordination compounds comprising gallium containing compound anions according to formula (1-1) highly attractive for application in organic electronic devices, and specifically in electroluminescent device for example by using the materials according to the invention as emitter materials. In this description, an electroluminescent electronic device may be any device or structure including substantially organic layers or subunits, where a voltage or current stimulus may be converted into electromagnetic radiation. In various embodiments the emission is substantially in the visible spectral region, for example between 430 to 780 nm. In various other embodiments the emission is partly of completely invisible to the human eye and may be in the near infrared spectral region for example between 780 to 1600 nm. Combinations of the two and complete or partial emission at shorter wavelength than visible light are in the scope of the invention too. Preferably, the electroluminescent device according to the invention emits light in the visible spectral region, and more preferably in the blue spectral region, with the generated light being substantially emitted between 430 to 500 nm.

The coordination compounds according to the invention have desirable material properties such as a deep blue emission spectrum combined with high operational stability. In particular, and preferably, using lanthanide coordination compounds with deep blue intrametallic d-f transitions, the coordination compounds according to the invention can serve as direct or indirect emitter giving rise to excellent device characteristics. Of special interest in this respect are emitters based on Ce(III), EuII), and Yb(II), preferably Ce(III), and Eu(II); and most preferably the emitter is a Ce(lll) coordination compound. Given their high atomic weight and open shell septet multiplicities, the optical transition of those three preferred lanthanide cations will be as well widely indifferent to excitation with either spin 1 or spin 0 electron-hole pairs. In other words, singlet and triplet excitations are harvested, resulting in high light emission efficiency. As such, the gallium containing compound comprising coordination compounds according to various embodiments comprising Ce(III), EuII), and Yb(ll) will be ideally suited for application in visible, particularly deep blue emitting, organic light emitting diodes.

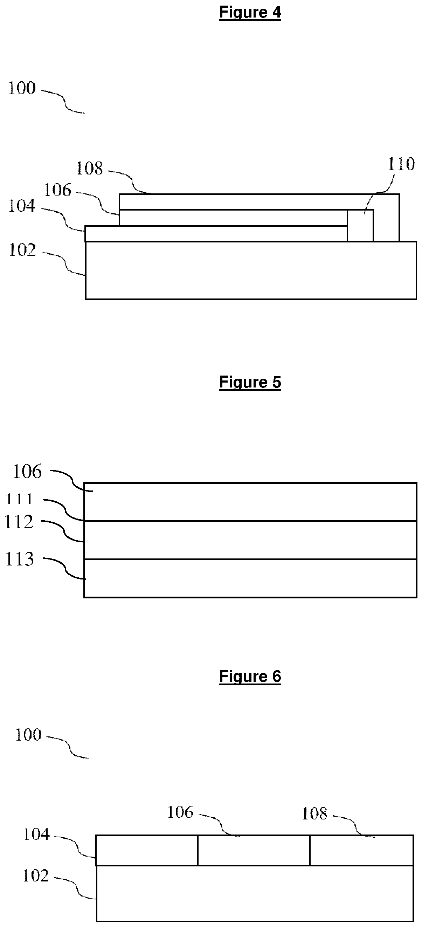

**FIG.** 4 to **FIG. 6** illustrate embodiments of an electroluminescent device 100. The device includes a first electrode 104, e.g. on a substrate 102 or as the substrate; a second electrode 108; and an organic layer 106 arranged such that it is electrically interposed between the first and second electrodes 104, 108. The first and second electrodes 104, 108 can be electrically insulated from each other by an insulating structure 110, e.g. a resin or polyimide. The first and second electrodes 104, 108 can be stacked over each other (FIG. 4) or can be arranged in a common plane (FIG. 6).

The organic layer 106 can include the coordination compound according to any of the described or illustrated embodiments, e.g., the layer can contain just the coordination compound, or a mixture with a further organic or non-organic material.

The organic layer 106 is arranged electrically between the first and second electrodes 104 and 108, such that an electronic current can flow from the first electrode 104 through the organic layer 106 to the second electrode 108 and vice versa during operation, e.g., during light emission. In other words, upon application of sufficient voltage, holes and electrons are injected from the anode and the cathode, respectively. From there, they drift towards the organic layer 106, where charges of opposite sign recombine to form a short-lived localized excited state. The short-lived excited state can relax to the ground state thereby giving rise to light emission. The organic layer 106 may or may not comprise mobile anions of organic or inorganic nature. Such mobile anions may rearrange upon application of sufficient electric field upon application of sufficient voltage between the electrodes 104 and 108. Such device is typically referred to as an organic light emitting cells (LECs) and within this description is considered as a subclass of electroluminescent devices comprising mobile charged species inside the active organic layer 106, which are able to drift inside an external applied electrical field. As such OLEDs encompass LEC type devices.

The first and second electrodes 104, 108 can be substantially unstructured layers, e.g., for general lighting applications, or can be structured, e.g., for light emitting diodes for pixels in a display application.

The organic electronic device 100 can be configured to emit substantially monochromatic light, such as red, green, blue, or polychromatic light such as white. The light can be emitted through the first electrode 104 (bottom emitter), through the second electrode 108 (top emitter), or through first and second electrodes 104 and 108 (bidirectional emitter). The light may as well be emitted substantially in a direction parallel to the organic layer 106 using suitable opaque electrodes 104 and 108. In such a layout, lasing may be achieved, and the device can be an organic laser, which, in this description, can be considered as a specific type of electroluminescent devices.

Further layers can be formed and can be in electrical connection between the first and second electrodes 104, 108, e.g., configured for charge carrier (electron or hole) injection, configured for charge carrier transport, configured for charge carrier blockage or configured for charge generation. Further optically functional layers, e.g., a further electroluminescent material and/or a wavelength conversion material can be formed between the first and second electrodes 104, 108 and in the optical path of the organic layer 106, e.g., on top of the second electrode 108 and/or on the opposite side of the substrate 102. In addition, encapsulation structures can be formed encapsulating the electrically active area, e.g., the area in which electrical current flows and can be configured to reduce or avoid intrusion of oxygen and/or water into the electrically active area. Further optically functional layers, e.g., an antireflection coating, a waveguide structure and/or an optical decoupling layer can be formed within the optical light path of the organic layer 106.

As example, hole or electron blocking layers can be used to optimize the individual hole and electron currents through the organic electronic device 100. This will be known to those skilled in the art as charge balance to optimize efficiency and operational stability. In various embodiments, dedicated hole or electron charge transport layers may be present in the organic electronic device 100 to space the emission region from the first and second electrodes 104, 108.

Examples of hole transport materials include known materials such as fluorene and derivatives thereof, aromatic amine and derivatives thereof, carbazole derivatives, dibenzofuran, dibenzothiophene, and polyparaphenylene derivatives. Examples of electron transport materials include oxadiazole derivatives, triazine derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and its derivative, diphenoquinone derivatives, and metal complexes of 8-hydroxyquinoline and its derivatives and various derivatives of silanes.

In various embodiments, those charge transport layers can include electrical dopant molecules or metals or can be in contact to charge injection layers.

Any of those auxiliary layers can be fully organic or can include inorganic functional moieties. For example, charge transport layers can be made of the class of Perovskite materials.

The coordination compound according to the invention as illustrated or described in any one of the embodiments can be used as a thin substantially organic emission layer 106 of any thickness in the range of from 0.1 to 100 nm, preferably in the range of from 3 to 40 nm. The concentration of the coordination compound throughout the cross section of the organic layer 106 can be constant or varied. Typical variable concentrations are in the range of from 0 to 100 vol%, i.e., the layer can be partially containing either no coordination compound or just coordination compound. Such situations are indeed frequently observed if mobile evaporation sources are employed to co-sublime the organic material with the coordination compound. The emission layer 106 can as well be configured such that the metal-organic coordination compound according to the invention is present in two adjacent layers, with a different second organic material, for example a host, being present in both layers.

**Fig. 5** illustrates a schematic cross section through an organic layer 106 comprising 3 organic sublayers 111, 112, and 113. The electroluminescent device according to the invention can for example comprise the combination of a substantially hole transporting material in combination with the coordination compound according to the invention in layer 112, whilst the same coordination compound is mixed with a substantially electron transporting organic host material in layer 113. Alternatively, the concentration of the coordination compound according to the invention imbedded into a single second material can be substantially different thereby again forming two adjacent layers 112 and 113, with preferably different charge transport qualities.

An optional second organic material being present in the layer containing the coordination compound according to the invention such as the organic layer 106 can in various embodiments be a charge transport material to improve the charge transport into and through the organic layer 106 or to facilitate the charge recombination. Charge transport materials can be any material that are able to transport either holes or electrons or both types of charges upon applying a suitable electrical field. In particular a charge transport material can be any aryl, or heteroaryl organic compound or any metal complex or any mixture thereof. Without limiting the scope of the invention, examples of materials present in the light emitting layer 106 include carbazole derivatives, including carbazole-phosphine oxide materials, oxadiazole derivatives, triazine derivatives, silane derivatives and any other material or combination of materials with sufficiently high triplet level that can transport charges or otherwise benefit the device performance.

In various embodiments, the gallium (containing compound) containing coordination compound according to the invention is used as emitting material within the organic layer 106 of the electroluminescent device according to the invention. In various preferred embodiments, the coordination compound according to the invention is not directly emitting light but is in optical contact to a second emitter. The second emitter is preferably part of the organic layer 106 too. Preferably, the optical contact is achieved via direct energy transfer, i.e. so-called Förster resonance energy transfer. In various other preferred embodiments, the charge recombination occurs substantially on the metal organic coordination compound according to the invention and its energy is substantially transferred to a second emitter. In preferred embodiments, and in order to ease energy transfer, the second emitter has a lower excitation energy as compared to the emission energy of the undisturbed coordination compound according to the invention. The second emitter is preferably configured as fluorescent emitter characterized by a low inter-system-crossing rate, preferably and after optical excitation the intersystem crossing yield is less than 50% and preferably less than 10%. The fluorescent emitter, often referred to as the terminal emitter, preferably has a partial concentration within the organic layer 106 of less than 10 wt%, preferably less than 5 wt%. In preferred embodiments, the fluorescent emitter has a narrow emission spectrum, preferably in the blue spectral region. In various preferred embodiments, the coordination compound used in the device comprises Ce(III). Further preferred are terminal emitter comprises a rigid polycyclic aromatic framework, specifically comprising a Boron-Nitrogen-heterocycle. Most preferably, the terminal emitter is a substituted derivative of 5,9-diphenyl-5,9-diaza-13b-boranaphtho[3,2,1-de]anthracene, with preferred substitutions being tert-butyl or carbazolyl groups.

The organic layer 106 that contains the coordination compound according to the invention can contain any further organic or inorganic material in a range of from 0.1 to 99.0 vol% that is not intended to transport charges. For example, the organic layer 106 can include polymers (in a mixture or as a compound) which can be added to improve film quality and prevent crystallization. Other materials can be added to evenly space the coordination compound inside the organic layer 106.

In various embodiments, the electroluminescent device 100 includes two or more subunits each including at least one light emitting layer. The subunits can be stacked over each other, physically separated and electrically connected by a charge generation layer, or, alternatively, can be arranged side by side. The subunits can be subpixels of a pixel in a display or general lighting application. The light emitted by the subunits can be mixed to generate a light of a predetermined color. Each subunit can emit light of the same or a different color. The overall light emitted by such an electroluminescent device 100 may contain a narrow spectral region, such as blue, or may contain a wide spectral region such as white, or a combination thereof. In other embodiments one of the subunits is emitting visible light and the second unit is emitting near infrared light. The coordination compound according to the invention comprising one or more gallium containing compound anions illustrated or described in any one of the embodiments may or may not be present in each individual subunit of the device 100.

In various embodiments, the light emitted by the electroluminescent device 100 can be in optical contact to at least one optically active layer, including any optically active materials such as organic molecules or quantum dots. The optically active layer can be a spectral filter element, which can absorb part of the light emitted by the device 100. In another embodiment, the optically active layer can absorb at least part of the light emitted by the organic electronic device 100 and can reemit it at longer wavelength (wavelength conversion), e.g., by quantum dots. As an example, the organic layer 106 can be configured to emit light substantially at wavelengths shorter than 500 nm and the optically active layer can be configured to substantially reemit light at wavelengths longer than 500 nm. The optically active layer can be placed in between the anode and cathode of the organic electronic device 100 or outside of it. The optically active layer can as well be part of the organic layer 106.

The term "substantially" can refer to (relative) amounts of a compound and typically means at least 80 wt% preferably at least 90 wt%, more preferably at least 95 wt%, specifically 100 wt%, not considering impurities or additives. It can define ranges of 80 to 100 wt% etc. for the content or purity of a compound. This definition refers e.g. to amounts like weight or volume or other parameters like wavelength. For single values, "substantially" allows for a variation or deviation from a given number by 20% or less, preferably 10% or less, more preferably 5% or less, specifically 1% or less. An emission substantially in the deep blue spectral region below 500 nm means that at least 80% of the emission are below 50 nm etc., e.g. of a measured integral of the emission intensity over wavelength. A substantially organic substrate contains at least 80% of organic substances. When not indicated otherwise, % means wt%.

The electroluminescent device 100 can be configured as a large area OLED device used for illumination, signage, or as a backlight. Alternatively, the electroluminescent device 100 can include a plurality of OLEDs arranged in a pixelated layout (plurality of OLED pixels) that are individually connected electrically, e.g., for flat panel display applications. Here, individual pixels can have the capability of emitting light of substantially narrow spectral portions; especially of red, green, and blue. The mixture may or may not be present in any of the individual pixels.

In another embodiment, the individual pixels can be configured to emit white light. Red, green, and blue spectral portions are generated by using suitable filter elements in optical contact with the respective pixelated OLEDs.

In another embodiment, the OLED pixels emit blue light, and the red and green spectral portions can be generated by using a suitable color conversion element in optical contact with the OLED pixels.

In another embodiment, the OLED pixels emit substantially in the near-UV spectral region with wavelength < 450 nm and the red and green and blue spectral portions can be generated by using a suitable color conversion element in optical contact with the OLED pixels.

An electroluminescent device 100 according to various embodiments can be fabricated using a wide range of commonly used techniques, including, but not limited to, deposition of all or some layers, from gas phase vacuum deposition, solution phase, or gas phase using a carrier gas method.

Owning to the high robustness of the gallium containing compound anions, in various preferred embodiments, deposition via the gas phase in vacuum can be used, whereby the coordination compound can either undergo sublimation or evaporation and can be co-deposited with a second organic material thereby forming mixed layers. The transfer into the gas phase can be further improved by using a carrier gas technology, whereby an inert gas that cannot be deposited into the organic layer comprising the coordination compound assist the sublimation or evaporation of the coordination compound. During the deposition process from gas phase, the coordination compound can be co-deposited with a second organic material using two separate thermal sources, in other words, a mixture is formed in-situ during deposition. During such co deposition two or more additional materials can be deposited using a triple or quadruple evaporation, whereby the coordination compound according to the invention is further diluted. Alternatively, the metal-organic complex according to the invention may as well be thermally processed from one crucible. In other words, a mixture or a precursor thereof is already present before sublimation or evaporation. A precursor can for example be an additional auxiliary ligand present as part of the coordination compound that dissociates during thermal evaporation and that is substantially not built into the organic layer comprising the coordination compound according to the invention. Preferred in this situation are similar volatilities for the second organic material and the coordination compound. Alternatively, the coordination compound and the second organic material can form a frozen glass, thereby forcing the individual components to sublime at similar temperatures.

Another preferred technique to fabricate organic layers including the coordination compound according to various embodiments can be deposition from a liquid phase using a mixture of or a single organic solvent, whereby the coordination compound according to various embodiments can be dissolved or forms a suspension within the organic solvent; in this description can be referred to as the ink. The ink using this deposition process can include a wide variety of other materials apart from the coordination compound according to various embodiments to allow fabrication of triple or higher-order mixed layers from solution. Additives within the ink can for example( but will not be limited to) be organic or inorganic materials capable of transporting charges, materials that improve the film formation, materials that improve the distribution of the coordination compound according to the invention within a third material, organic or inorganic materials that improve the efficiency of the device, e.g., by reducing the refractive index. The deposition from solution will not be limited to any specific technique. Examples of the deposition from solution include spin coating, casting, dip coating, gravure coating, bar coating, roll coating, spray coating, screen printing, flexographic printing, offset printing, inkjet printing.

Various post processing techniques may be applied to improve the performance or stability of the electroluminescent device. In one embodiment, some or all layers of the organic electronic device include functional groups capable of chemically crosslinking upon thermal or electromagnetic exposure thereby forming larger covalently bound molecules with improved physical properties. In another embodiment functional groups are present in a second organic material and after crosslinking the second organic material becomes a polymer with the coordination compound according to the invention being embedded into. In yet another embodiment functional groups capable of crosslinking are present on both, the coordination compound and a second organic material, and after crosslinking, a single polymeric material covalently linking a second organic material with the metal-organic coordination compound according to the invention is formed.

The present invention is further illustrated by the following first set of embodiments and combinations of embodiments resulting from the dependencies and back-references as indicated. In particular, it is noted that in each instance where a range of embodiments is mentioned, for example in the context of a term such as "The process of any one of embodiments 1 to 4", every embodiment in this range is meant to be explicitly disclosed for the skilled person, i.e. the wording of this term is to be understood by the skilled person as being synonymous to "The process of any one of embodiments 1, 2, 3 and 4". Further, it is explicitly noted that the following set of embodiments represents a suitably structured part of the general description directed to preferred aspects of the present invention, and, thus, suitably supports, but does not represent the claims of the present invention. The following are preferred embodiments of the invention. The respective features can be freely combined with each other without departing from the present invention.
1. An organic electroluminescent device comprising:
   a first electrode,
   a second electrode, and
   an organic layer disposed between the first electrode and the second electrode,
   the organic layer comprising at least one charge-neutral metal-organic coordination compound, with the metal-organic coordination compound comprising at least one electrically negatively charged gallium compound of general formula (1-1): 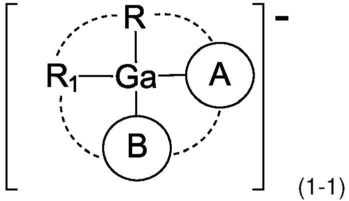 with
      - **A,** and **B** independently being substituted or non-substituted heterocyclic rings, preferably aromatic heterocycles which preferably comprise one or more nitrogen ring atoms, and
      - **R** and **R₁** independently in each instance representing hydrogen, deuterium, or organyl groups, and
      - **broken lines** between the rings A and B and between the ring B and an organyl fragment R₁, and between the ring A and an organyl fragment R, and between two organyl fragments R and R₁ indicate each independently either that those respective organyl fragments A, B, R and R₁ are not connected at any position, or that those respective organyl fragments A, B, R and R₁ are directly connected through a chemical bond at any available position of each, or that those respective organyl fragments A, B, R and R₁ are connected via a linking group at any available position of each .
2. The electroluminescent device of embodiment 1, with at least one, preferably both, of the rings A and/or B independently, preferably identically, being selected from the group consisting of substituted or non-substituted imidazole-2-yl, imidazole-4-yl, pyrazolyl, 1,2,3-triazolyl, 1,2,4-triatolyl, thiazolyl, isothiazolyl, oxazolyl, 1,3,4-oxadiazole-yl, and 1,2,4-thiadiazolyl.
3. The electroluminescent device of embodiment 1 or 2, with both rings A and B being identically substituted pyrazolyl, preferably with substitutions in 3- and 5- position, and even more preferably with an identical substituent in the 3- and the 5- position, and even more preferably the substituent being alkyl or heteroalkyl, most preferably methyl or ethyl.
4. The electroluminescent device of one of embodiments 1 to 3, with R and R₁ each independently being selected from substituted or non-substituted alkyl, preferably non-substituted alkyl, most preferably methyl, ethyl, or propyl, or being selected from substituted or non-substituted aryl or heteroaryl, preferably pyrazolyl or phenyl, the phenyl preferably being a mesityl.
5. The electroluminescent device of one of embodiments 1 to 4, with the metal-organic coordination compound comprising at least one electrically negatively charged gallium compound of general formula (1-4) 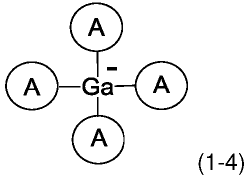
   with **A** being identical, substituted or non-substituted heterocyclic rings, preferably aromatic heterocycles, preferably comprising one or more nitrogen ring atoms more preferably being substituted or non-substituted pyrazolyl,
   or with the metal-organic coordination compound comprising at least one electrically negatively charged gallium compound of general formula (1-2): 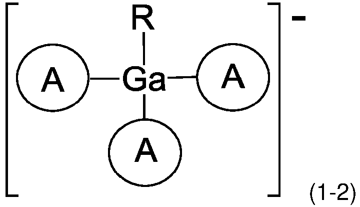
   with **A** being identical, substituted or non-substituted heterocyclic rings, preferably aromatic heterocycles, preferably comprising one or more nitrogen ring atoms more preferably being substituted or non-substituted pyrazolyl, R representing hydrogen, deuterium, or an organyl group!, preferably aryl, more preferably mesityl,
   or with the metal-organic coordination compound comprising at least one electrically negatively charged gallium compound of general formula (1-3): 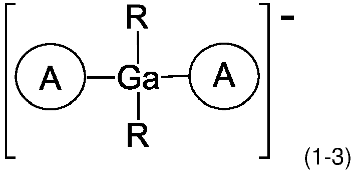
   with both **A** being identical, substituted or non-substituted heterocyclic rings, preferably aromatic heterocycles, preferably comprising one or more nitrogen ring atoms , more preferably substituted or non-substituted pyrazolyl, both **R** being identical, representing hydrogen, deuterium, or organyl groups, preferably aryl, more preferably mesityl.
6. The electroluminescent device of one of embodiments 1 to 5, with the at least one electrically negatively charged gallium compound present as part of the charge-neutral metal-organic coordination compound being selected from G1 to G15: 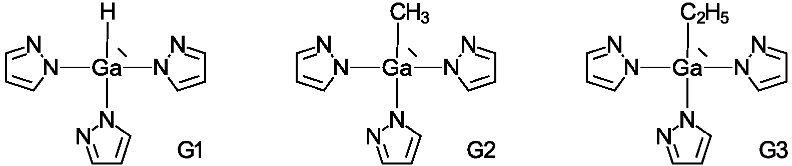 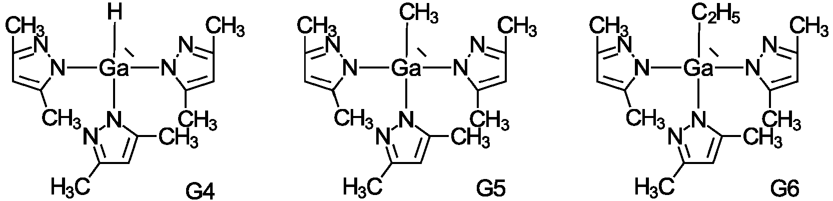 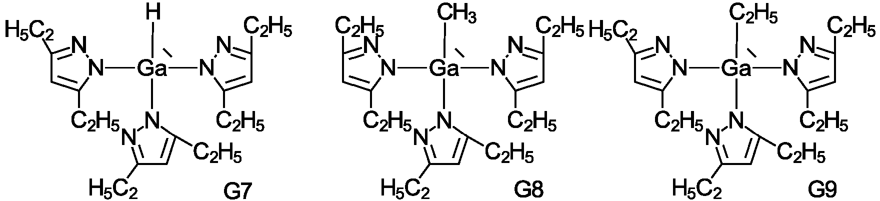 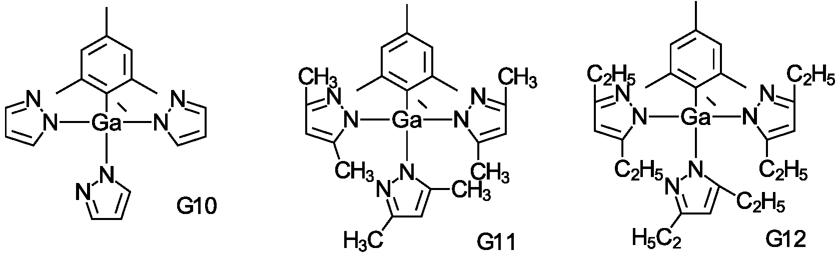 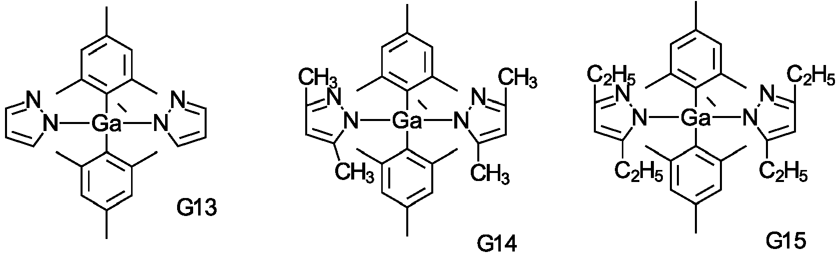
7. The electroluminescent device according to one of embodiments 1 to 6, with the charge-neutral metal-organic coordination compound comprising at least one additional metal besides the gallium of the electrically negatively charged gallium compound, with this at least one additional metal being electrically positively charged, and preferably being selected from the group consisting of alkali metals, alkali earth metals, lanthanides, and transition metals, preferably being selected from the group consisting of alkali metals and lanthanides, preferably with the at least one additional metal cation, present as part of the metal-organic coordination compound being twofold or higher electrically positively charged and with the metal-organic coordination compound comprising one or more charge-neutral or electrically negatively charged ligands, which are different from the electrically negatively charged gallium compounds of formulae (1-1), (1-2) and (1-3).
8. The electroluminescent device according to embodiment 7, with the at least one additional metal cation being threefold positively charged and with the coordination compound comprising two, preferably identical, electrically negatively charged gallium compounds according to formula (1-1), (1-2) or (1-3) as ligands and a third singly electrically negatively charged ligand, which is preferably identical to the ring A or B present in any of the formulae (1-1), (1-2) or (1-3), or is a substituted ring A or B thereof..
9. The electroluminescent device according to one of embodiments 1 to 8, with the organic layer disposed between the first electrode and the second electrode additionally comprising at least one phosphorescent light emitting material which . preferably emits substantially in the blue spectral region and/or comprises a metal cation selected from Pt(II) and Ir(III).
10. The electroluminescent device according to one of embodiments 1 to 9, with the organic layer disposed between the first electrode and the second electrode additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.
11. A charge-neutral metal-organic coordination compound comprising at least one lanthanide cation with the at least one lanthanide cation being coordinated by at least one electrically negatively charged gallium compound of general formula (1-1) as ligand compound of general formula (1-1): 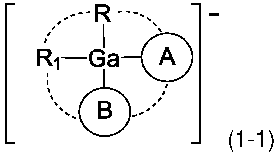 with
   - A, and B independently being substituted or non-substituted heterocyclic rings, preferably aromatic heterocycles which preferably comprise one or more nitrogen ring atoms, and
   - R and R1 independently in each instance representing hydrogen, deuterium, or organyl groups, and
   - broken lines between the rings A and B and between the ring B and an organyl fragment R1, and between the ring A and an organyl fragment R, and between two organyl fragments R and R1 indicate each independently either that those respective organyl fragments A, B, R and R1 are not connected at any position, or that those respective organyl fragments A, B, R and R1 are directly connected through a chemical bond at any available position of each, or that those respective organyl fragments A, B, R and R1 are connected via a linking group at any available position of each.
12. The coordination compound according to embodiment 11, with the at least one lanthanide cation being selected from the group consisting of La(III), Ce(IV), Ce(III), Pr(III), Nd(III), Sm(III), Eu(II), Eu(III), Gd(III), Tb(III), Dy(III), Ho(III), Er(III), Tm(III), Yb(II), Yb(III), or Lu(III), preferably Ce(lll) and Gd(III).
13. The coordination compound according to embodiment 12, in which the at least one lanthanide cation is threefold electrically positively charged and coordinated by three identical or different electrically negatively charged gallium compounds of general formula (1-1) as ligands, preferably the three electrically negatively charged gallium compounds of general formula (1-1) as ligand being identical to each other, more preferably the rings A and B in general formula (1-1) being identical to each other, or with the at least one lanthanide cation being threefold electrically positively charged and coordinated by two identical or different electrically negatively charged gallium compounds of general formula (1-1) and a third singly electrically negatively charged compound which is not a gallium compound as ligands, preferably the two electrically negatively charged gallium compounds of general formula (1-1) being identical to each other, more preferably the rings A and B present in formula (1-1) of the electrically negatively charged gallium compounds of general formula (1-1) being identical to each other, and preferably the third singly electrically negatively charged compound being preferably identical to the rings A, or B present in formula (1-1) of the electrically negatively charged gallium compounds of general formula (1-1), or being a substituted ring A or B thereof.
14. The coordination compound according to one of embodiments 11 to 13, which is selected from formulae C1 to C15: 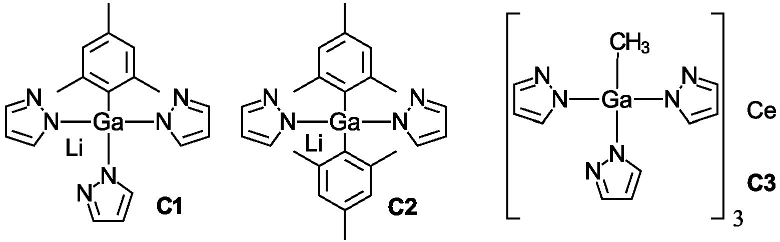 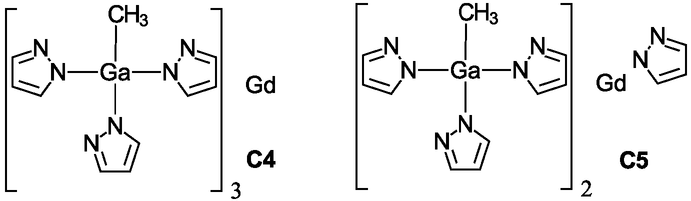 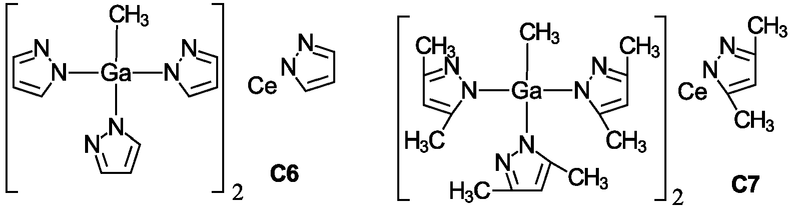 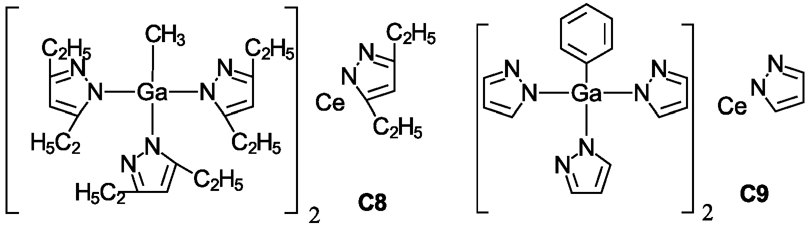 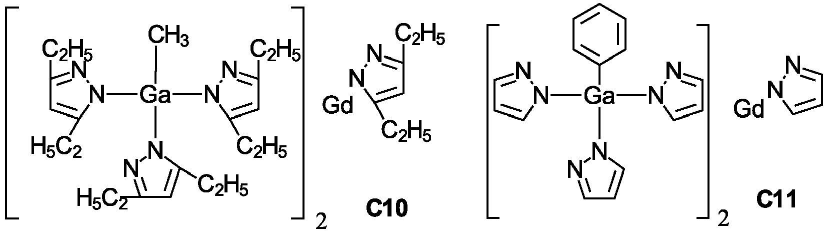 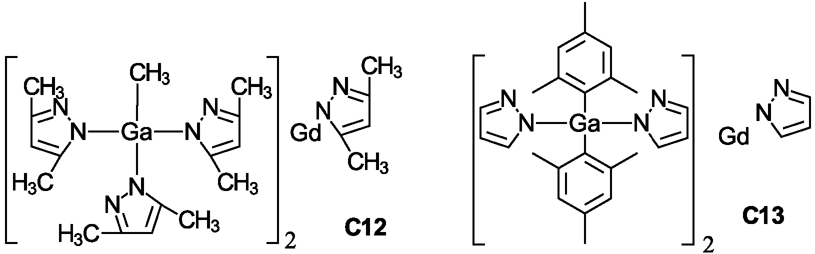 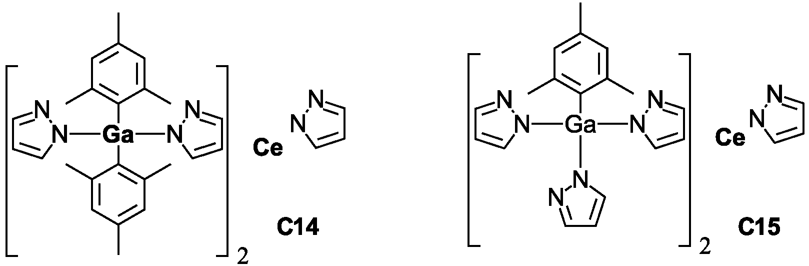
15. A process for preparing the electroluminescent device according to one of embodiments 1 to 10, wherein the organic layer comprising the charge-neutral metal-organic coordination compound is deposited from a gas phase, preferably using an evaporation and/or sublimation and/or carrier gas process, or is deposited by deposition from solution.
16. The electroluminescent device according to one of embodiments 1 to 10, wherein the device is an OLED display device.
17. The electroluminescent device according to embodiment 16, wherein the OLED display device is part of a TV set, laptop computer, smartphone, tablet, monitor or display device, containing the electroluminescent device according to one of embodiments 1 to 10.
18. The use of electrically negatively charged gallium compounds of general formula (1-1) as defined in one of embodiments 1 to 6 as ligands in charge-neutral metal-organic coordination compound that preferably contain an additional metal ion as defined in one of embodiments 7 to 9, 11 or 12.
19. The use of electrically negatively charged gallium compounds of general formula (1-1) as defined in one of embodiments 1 to 6 as ligands in organic emission layers of electroluminescent devices.
20. The use of charge-neutral metal-organic coordination compounds as defined in one of embodiments 11 to 14 in organic emission layers of electroluminescent devices.
21. A mixture comprising electrically negatively charged gallium compounds of general formula (1-1) as defined in one of embodiments 1 to 6, and additionally comprising at least one phosphorescent light emitting material which preferably emits substantially in the blue spectral region and/or comprises a metal cation selected from Pt(II) and Ir(III), and preferably additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.
22. A mixture comprising charge-neutral metal-organic coordination compounds as defined in one of embodiments 1 to 8 or 11 to 14, and additionally comprising at least one phosphorescent light emitting material which preferably emits substantially in the blue spectral region and/or comprises a metal cation selected from Pt(II) and Ir(III), and preferably additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.
23. A TV set, laptop computer, smartphone, tablet, monitor or display device, containing an electroluminescent device according to one of embodiments 1 to 10 or 16, a charge-neutral metal-organic coordination compound according to one of embodiments 11 to 14, an electrically negatively charged gallium compound of general formula (1-1) as defined in one of embodiments 1 to 6, a mixture as defined in embodiment 21 or a mixture as defined in embodiment 22.

For one or more aspects, at least one of the components set forth in one or more of the preceding figures can be configured to perform one or more operations, techniques, processes, and/or methods as set forth in the example section below.

### Examples

The examples set forth herein are illustrative and not exhaustive.

Any of the examples may be combined with any other example (or combination of examples), unless explicitly stated otherwise. The foregoing description of one or more implementations provides illustration and description but is not intended to be exhaustive or to limit the scope of aspects to the precise form disclosed. Modifications and variations are possible in light of the above teachings or may be acquired from practice of various aspects. Any of the above-described embodiments may be combined with any (other) example as mentioned below (or combination of examples), unless explicitly stated otherwise.

### Syntheses of various coordination compounds

All experimental manipulations were carried out under an inert atmosphere. Tetrahydrofuran (Acros Organics, extra dry, AcroSeal) was dried and distilled from K/benzophenone or purchased as anhydrous from Acros Organics. Toluene (Acros Organics, Extra Dry, AcroSeal) purchased as anhydrous from Acros Organics, Methanol (Acros Organics, Extra Dry, AcroSeal) purchased as anhydrous from Acros Organics.

### 1. Synthesis of Sodium tris(1-pyrazolyl)boranuide:

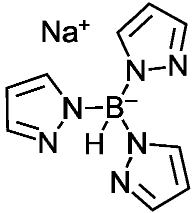

The compound was synthesized according to literature: a) Trofimenko, S. Inorganic Synthesis 1970, 7 (3), 99; b) Kaufmann, D. E. et. al. Science of Synthesis 2005, 6. c) Fang, P. et. al. ACS Appl. Mater. Interfaces 2021, 13, 45686. Yield: 36.5 g (84%) and analytics according to literature.

### 2. Synthesis of Cerium tris[tris[1-pyrazolyl)boranuide], used in comparative device examples, named hereafter as CE-1:

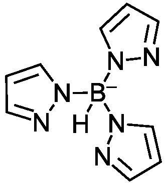

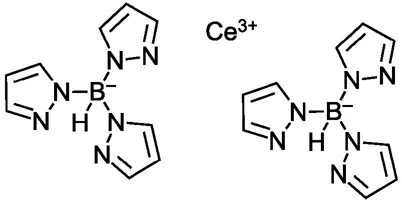

The compound was synthesized according to the literature: a) Bagnall, K. W. et. al. Inorg. Nucl. Chem. Lett. 1976, 12, 555; b) Apostolidis, C. et. al. Polyhedron 1997, 16 (7), 1057; c) Zasimov, P. et. al. Inorg. Chem. 2022, 61, 1817. Yield: 5.0 g (94%).

### 3. Synthesis of Sodium tris(1H-pyrazol-1-yl)(methyl)gallanuide, C-75:

*Step 1. 6.03* g (226.0 mmol, 1.1 eq.) of sodium hydride (90%) is suspended in 25 mL dry THF under nitrogen atmosphere. A solution of 14.0 g (206.0 mmol, 1.0 eq.) pyrazole in 100 mL anhydrous THF is slowly added via a dropping funnel. The reaction mixture is allowed to stir at room temperature until no H2 evolution is visible anymore. The solvent is removed in vacuo, the residual is extracted by stirring in hexane. The solid is filtered off, washed with hexane and dried. The product was isolated as colorless solid. Yield: 18.5 g (100%).

*Step 2.* To 19.4 g of cold tetramethylsilane (220.0 mmol, 3.4 eq.) in an inert atmosphere is 11.3 g of gallium(III)chloride (64.1 mmol, 1.0 eq.) added portion wise. The reaction is allowed to stir over night. The liquid is removed in vacuo, the residue is purified through sublimation. Dichloro(methyl)gallane is isolated as colorless crystals. Yield: 8.8 g (88%).

*Step 3.* To a solution of 9.19 g sodium pyrazolyde (102.0 mmol, 3.0 eq.) in 332 mL anhydrous THF is dropwise added 5.3 g dichloro(methyl)gallane (34.0 mmol, 1.0 eq.) in 5 mL cold dry THF under Schlenk conditions. After two days of stirring the precipitate is filtered off and washed with dry THF. The filtrate is diluted to a stock solution of 0.08 M (425 mL). Yield: 10.5 g (100%).

1H-NMR (80 MHz, THF-d8): δ (ppm) = 7.44 (s, 4 H), 5.90 (s, 2 H), 0.19 (s, 3 H).

### 4. Synthesis of Cerium pyrazolydo-bis(methyltrispyrazolyl)gallat, C-3:

*Step 1*. The reaction was carried out in a glovebox. To 10.0 mL (1.6 mmol, 1.0 eq.) of **C-75** solution (0.08M in THF) under a nitrogen atmosphere is added 0.15 g (1.6 mmol, 1.0 eq.) trimethylamine hydrochloride and stirred overnight. The turbid reaction mixture is evaporated to complete dryness. The residue is dissolved again in little THF. 0.32 g (0.51 mmol, 0.3 eq.)) of cerium(III)tris(bis(trimethylsilyl)amide) is dissolved in a small amount of THF and added to the solution. The solvent is removed after complete conversion and the product is purified through sublimation. Yield: 0.31 g (59%).

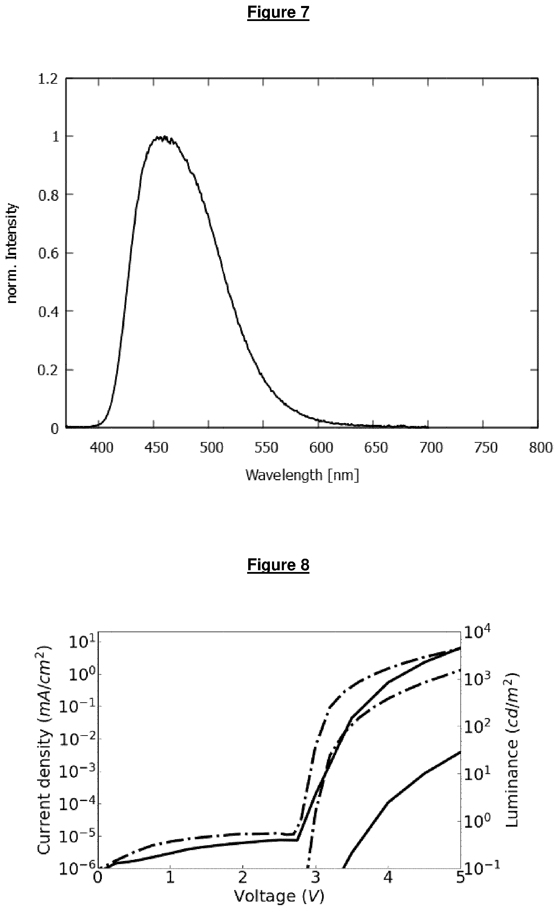

The purity of the sublimed material was probed using an HPLC method using an ELSD detector. A high purity of 99.45% was measured. Elementary Analysis was performed on the final sublimed product: C30H36CeGa3N18; Calc.: C: 36.10%; H: 3.64%; N: 25.26%; found: C: 35.44%, H: 3.60%; N: 25.32%. The observed ratios confirm the structure of the compound very well. The photoluminescence emission spectrum of a 50 nm evaporated and encapsulated thin film of compound C-3 after optical excitation at 340 nm is depicted in **Fig. 7****.** The visible double peak emission is typical for cerium emitting materials. The spectrum testifies the deep blue emission of the metal organic complex, making it highly useful for the design of saturated deep blue electroluminescent devices.

### Electroluminescent device examples

Representative embodiments of organic electronic devices according to various embodiments will now be described, including a detailed description of the fabrication process of the organic electronic device. Yet, it will be understood that neither the specific techniques for fabrication of the device, nor the specific device layout, nor the specific compounds are intended to limit the scope of the present invention.

### Material definitions:

| | |
|---|---|
| ITO: | Indium tin oxide, transparent anode |
| MoO3: | Molybdenum oxide |
| Yb: | Ytterbium |
| Al: | Aluminium |
| Liq: | Lithium 8-quinolinolate |
| H1: | [3-(9-Carbazolyl)-9-oxa-1-fluorenyl]tris(phenyl)silane |
| H2: | Bis[3,5-di(9H-carbazol-9-yl)phenyl]diphenylsilane |
| H3: | 2-Phenyl-4,6-bis(3-(triphenylsilyl)phenyl)-1,3,5-triazine |
| H4: | 9,9'-(6-(3-(Triphenylsilyl)phenyl)-1,3,5-triazine-2,4-diyl)bis(9H-carbazole) |
| H5: | 1,3-Bis(9-phenyl-1,10-phenanthrolin-2-yl)benzene |
| H6: | [2-[3-[3-[3,5-bis(1,1-dimethylethyl)phenyl]-1H-benzimidazol-1-yl-_{K}C2]phenoxy-_{K}C2]-9-[4-(1,1-dimethylethyl)-2-pyridinyl-_{K}N]-9H-carbazolato(4-)-_{K}C1]-, (SP-4-4)-Platinum |

The materials MoO3, Yb, Liq, Al, H1, H2, H3, H4 are commercially available. H1, H2, H3, H4, H5, H6 were purchased from Jilin OLED Material Tech Co., Ltd., and from Shenzhen Puri Materials Technology Co., Ltd. The materials were purified by sublimation prior use.

### Device fabrication:

The organic electronic devices were prepared using the following generic layer sequences:
Device A: ITO / 2 nm MoO3 / 65 nm H2 / 5 nm H1 / 2 nm **C-3** / 5 nm H3 / 31.5:31.5 nm H3:Liq / 120 nm Al.
Device B: ITO / 2 nm MoO3 / 65 nm H2 / 5 nm H1 / 2 nm **CE-1** / 5 nm H3 / 31.5:31.5 nm H3:Liq / 120 nm Al.
Device C: ITO / 2 nm MoO3 / 65 nm H2 / 5 nm H1 / 24.5:10.5 nm H4:**C-3** / 5 nm H3 / 29.7:0.3 nm H5:Yb / 120 nm Al.
Device D: ITO / 2 nm MoO3 / 65 nm H2 / 5 nm H1 / 30.5:4.5 nm H4:H6 / 35 nm H3 / 2 nm **C-75/ 120** nm Al.
Device E: ITO / 2 nm MoO3 / 65 nm H2 / 5 nm H1 / 30.5:4.5 nm H4:H6 / 35 nm H3 / 2 nm **Liq** / 120 nm Al.
Device F: ITO / 2 nm MoO3 / 65 nm H2 / 5 nm H1 / 30.5:4.5 nm H4:H6 / 35 nm H3 / 120 nm Al.

Each organic electronic device was fabricated on a 1"x1" size glass substrate, pre-coated with a transparent ITO anode and a pixel definition layer (Geomatec). The substrates were loaded into an ultra-high vacuum evaporation tool operating at around 10-7 mbar pressure (Kurt J. Lesker Company). N2 plasma treatment was carried out on the substrates in a separate vacuum chamber prior organic layer deposition. The organic layers were deposited onto the substrate in the sequence stated above. In the case of more than one material present in the layer, the layer is homogeneously mixed using a simultaneous co-evaporation, with the intended mixing ratio achieved by setting the evaporation rates of each material accordingly. The device was finished by evaporating a 120 nm film of cathode Al. The Al deposition was carried out using a structured shadow mask, such that the resulting overlap of pre-structured ITO, organic layers and Al gave an active area of 3.88 mm2. Subsequently, the finished devices were transferred to a nitrogen atmosphere glovebox and encapsulated by gluing an additional encapsulating glass substrate on top to prevent oxygen- and water-induced degradation. A liquid getter is dispensed onto the encapsulating glass substrate which absorbs moisture. The electrical and electroluminescent properties of the device were measured using a calibrated, integrated OLED characterization setup M7000 (McScience inc.).

### Device results:

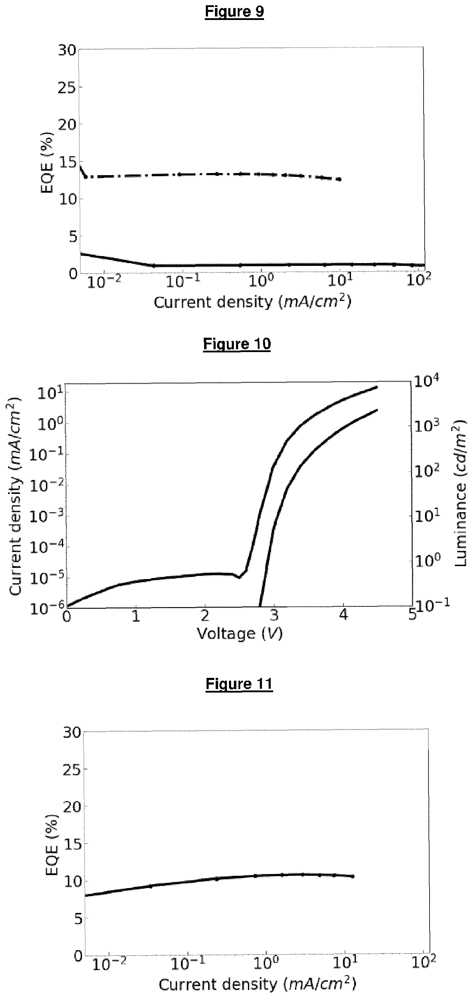

The devices A and B are designed in the way that allows for screening the complexes electroluminescent properties without using an organic host material. The devices feature a 2 nm emissive interlayer, where the material used in the interlayer is the investigated complex. The only difference between the two devices is therefore the choice of the emissive material, otherwise the devices are identical. Both devices emit in the deep blue spectral region. In **Fig 8** current-voltage-luminance (IVL) characteristics comparing the two devices A and B are depicted. Here, a solid line is used for the comparative device B using CE-1 as emitting layer, whilst a dash-dotted lines are used for the device according to the invention, A, employing CE-3 as emissive layer. Obviously, the device according to the invention, A, shows much higher currents (left axis) and significantly more light output (right axis) at a fixed voltage compared to the device B. In **Fig 9** the corresponding external quantum efficiencies (EQEs) of the two devices are plotted vs current density. The higher light output of the device according to the invention equates to an improvement in external quantum efficiency of more than a factor of ten as compared to the comparative example, device B. A further comparison of the most relevant device parameters is given in **Table 1** below.

The two materials CE-1 and C-3 are nearly identical with respect to their chemical composition. Both are based on non-substituted tris-pyrazolyl anions, but CE-3 employs conventional bor, while C-3 uses gallium. Identical electroluminescent devices have been made and the gallium containing compound metal-organic complex performs in all relevant device aspects significantly better as compared to the comparative example. Therefore, and without invoking any elaborated theoretical reasoning, the gallium containing compound type anion is superior to the conventional borate type anion in electroluminescent device applications.

Often, the emitting layers in OLED consist of at least one organic host material and the emissive material doped into the host. In a further example according to the invention, in device C, C-3 is mixed into a single charge transporting host material at 30wt%. The device emits deep blue electroluminescence with an emission spectrum peaking at 466nm. The voltage-current density-luminance (IVL) and current density-efficiency curves are shown in **Fig. 10** and **Fig. 11****,** respectively; the corresponding device performance at fixed current density is reported in **Table 1** below. The device shows desirable steep IV curves and very low diving voltage below 4 V. The efficiency of the device is comparably high, reaching 11% EQE, and the efficiency is only weakly dependent on driving condition, in other words, the efficiency curve is flat as a function of current density.

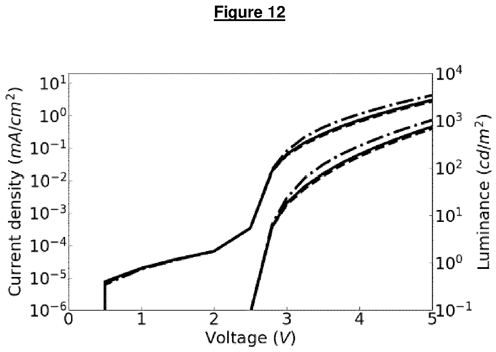

In OLED, each deposited material in each layer is associated with a specific function. Device A, B and C featured the complexes C-3, and CE-1 as the emissive materials inside the organic emission layer. In another embodiment of the invention, the same gallium containing compound type ligand as used in the emissive complex, C-3, is exemplified in a different use case, namely as electron injection layer. Devices D, E and F contain a conventional phosphorescent emissive complex within the emission layer based on Pt(ll) (Sun, J., Ahn, H., Kang, S. et al. Nat. Photon. 16, 212-218 (2022)) and the devices are designed to probe different or no electron injection layer between the aluminum cathode and the electron transporting layer made of the conventional triazine compound H3. The OLED according to the invention, Device D features the metal-organic complex C-75 as the electron injection material. Device E features Liq as the electron injection material, which is widely used in mass production and literature and serves as a comparative example. Device F features a device without any electron injection material, which serves as a comparative example too. To judge performance as electron injection layer, the most important metric is the current density at a certain applied voltage, i.e. the IV characteristics, which are shown for the three devices in **Fig. 12****.** The turn-on, i.e. the voltage to drive very low currents, is identically for all three devices at around 2.5V. At those conditions, the voltage is limited by the work-function offset of the two electrodes and not any of the barriers or mobilities within the organic layer stack. Significant differences become apparent between the three devices for current densities needed to drive relevant brightnesses, such as the here quoted 3.3mA/cm² which roughly corresponds to the standard brightness of 1000 cd/m². At those driving currents, the device without any injection layer (F, dashed line in Fig. 14) requires the highest voltages, closely followed by the comparative device using the Liq electron injection layer (E, solid line). Clearly, the device according to the invention (D, dashed-dotted line in Fig. 14) outperforms both the standard material Liq and having no injection layer and shows the highest current density at a given driving voltage. Referring to **Table 1,** it becomes apparent that the improved voltage does not negatively impact the device efficiency or electroluminescence spectrum peak position. Therefore, the improved voltage translates into a desirable improvement in power efficiency, potentially lowering the power consumption of an OLED display made accordingly.

Finally, for ease of comparison, driving voltages, external quantum efficiencies (EQE), and electroluminescence emission peak wavelength at a selected current density of 3.3 mA/cm2 for devices A-F are summarized in **Table 1** below:

**Table 1**

| Device | Use | V at 3.3 mA/cm², V | EQE at 3.3 mA/cm², % | EI peak, nm |
|---|---|---|---|---|
| A | Example according to invention | 4.5 | 13 | 472 |
| B | Comparative example | 4.63 | 1 | 480 |
| C | Example according to invention | 3.84 | 11 | 475 |
| D | Example according to invention | 4.78 | 16.9 | 466 |
| E | Comparative example | 5.11 | 16.8 | 466 |
| F | Comparative example | 5.15 | 16.4 | 466 |

## Claims

1. An organic electroluminescent device comprising:
a first electrode,
a second electrode, and
an organic layer disposed between the first electrode and the second electrode,
the organic layer comprising at least one charge-neutral metal-organic coordination compound, with the metal-organic coordination compound comprising at least one electrically negatively charged gallium compound of general formula (1-1): 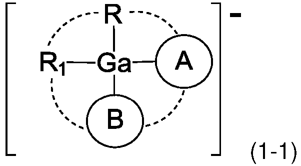 with
• **A,** and **B** independently being substituted or non-substituted heterocyclic rings, preferably aromatic heterocycles which preferably comprise one or more nitrogen ring atoms, and
• **R** and **R₁** independently in each instance representing hydrogen, deuterium, or organyl groups, and
• **broken lines** between the rings A and B and between the ring B and an organyl fragment R₁, and between the ring A and an organyl fragment R, and between two organyl fragments R and R₁ indicate each independently either that those respective organyl fragments A, B, R and R₁ are not connected at any position, or that those respective organyl fragments A, B, R and R₁ are directly connected through a chemical bond at any available position of each, or that those respective organyl fragments A, B, R and R₁ are connected via a linking group at any available position of each .

2. The electroluminescent device of claim 1, with at least one, preferably both, of the rings A and/or B independently, preferably identically, being selected from the group consisting of substituted or non-substituted imidazole-2-yl, imidazole-4-yl, pyrazolyl, 1,2,3-triazolyl, 1,2,4-triatolyl, thiazolyl, isothiazolyl, oxazolyl, 1,3,4-oxadiazole-yl, and 1,2,4-thiadiazolyl.

3. The electroluminescent device of claim 1 or 2, with both rings A and B being identically substituted pyrazolyl, preferably with substitutions in 3- and 5- position, and even more preferably with an identical substituent in the 3- and the 5- position, and even more preferably the substituent being alkyl or heteroalkyl, most preferably methyl or ethyl.

4. The electroluminescent device of one of claims 1 to 3, with R and R₁ each independently being selected from substituted or non-substituted alkyl, preferably non-substituted alkyl, most preferably methyl, ethyl, or propyl, or being selected from substituted or non-substituted aryl or heteroaryl, preferably pyrazolyl or phenyl, the phenyl preferably being a mesityl.

5. The electroluminescent device of one of claims 1 to 4, with the metal-organic coordination compound comprising at least one electrically negatively charged gallium compound of general formula (1-4) 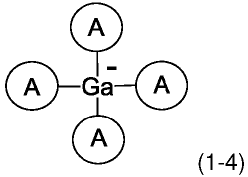
with A being identical, substituted or non-substituted heterocyclic rings, preferably aromatic heterocycles, preferably comprising one or more nitrogen ring atoms more preferably being substituted or non-substituted pyrazolyl,
or with the metal-organic coordination compound comprising at least one electrically negatively charged gallium compound of general formula (1-2): 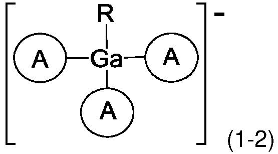
with A being identical, substituted or non-substituted heterocyclic rings, preferably aromatic heterocycles, preferably comprising one or more nitrogen ring atoms more preferably being substituted or non-substituted pyrazolyl, R representing hydrogen, deuterium, or an organyl group!, preferably aryl, more preferably mesityl,
or with the metal-organic coordination compound comprising at least one electrically negatively charged gallium compound of general formula (1-3): 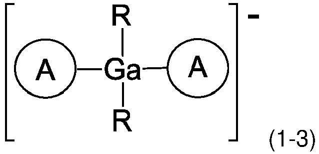
with both **A** being identical, substituted or non-substituted heterocyclic rings, preferably aromatic heterocycles, preferably comprising one or more nitrogen ring atoms , more preferably substituted or non-substituted pyrazolyl, both **R** being identical, representing hydrogen, deuterium, or organyl groups, preferably aryl, more preferably mesityl.

6. The electroluminescent device of one of claims 1 to 5, with the at least one electrically negatively charged gallium compound present as part of the charge-neutral metal-organic coordination compound being selected from G1 to G15:

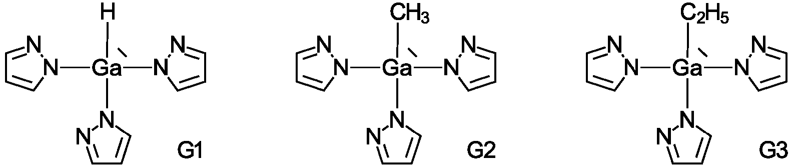

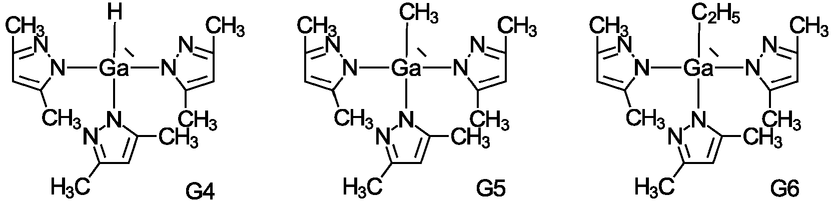

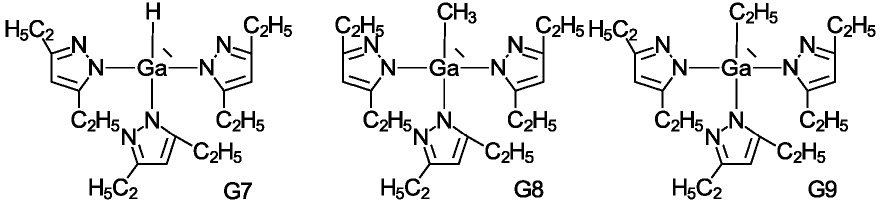

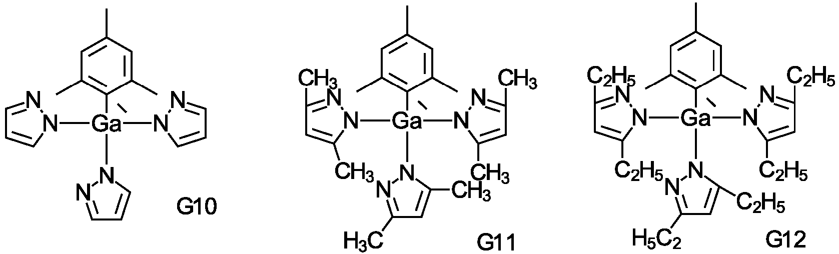

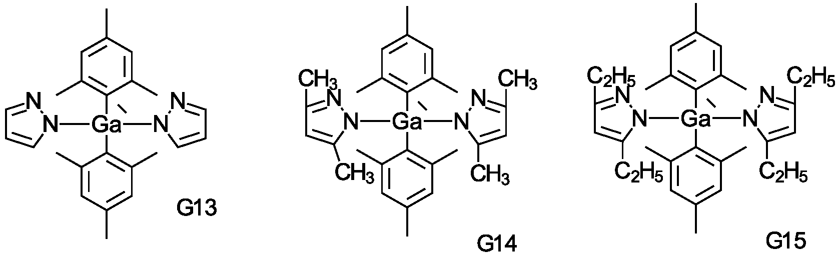

7. The electroluminescent device of one of claims 1 to 6, with the charge-neutral metal-organic coordination compound comprising at least one additional metal besides the gallium of the electrically negatively charged gallium compound, with this at least one additional metal being electrically positively charged, and preferably being selected from the group consisting of alkali metals, alkali earth metals, lanthanides, and transition metals, preferably being selected from the group consisting of alkali metals and lanthanides, preferably with the at least one additional metal cation, present as part of the metal-organic coordination compound being twofold or higher electrically positively charged and with the metal-organic coordination compound comprising one or more charge-neutral or electrically negatively charged ligands, which are different from the electrically negatively charged gallium compounds of formulae (1-1), (1-2) and (1-3).

8. The electroluminescent device of claim 7, with the at least one additional metal cation being threefold positively charged and with the coordination compound comprising two, preferably identical, electrically negatively charged gallium compounds according to formula (1-1), (1-2) or (1-3) as ligands and a third singly electrically negatively charged ligand, which is preferably identical to the ring A or B present in any of the formulae (1-1), (1-2) or (1-3), or is a substituted ring A or B thereof.

9. The electroluminescent device of one of claims 1 to 8, with the organic layer disposed between the first electrode and the second electrode additionally comprising at least one phosphorescent light emitting material which preferably emits substantially in the blue spectral region and/or comprises a metal cation selected from Pt(II) and Ir(III).

10. The electroluminescent device of one of claims 1 to 9, with the organic layer disposed between the first electrode and the second electrode additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.

11. A charge-neutral metal-organic coordination compound comprising at least one lanthanide cation with the at least one lanthanide cation being coordinated by at least one electrically negatively charged gallium compound of general formula (1-1) as ligand compound of general formula (1-1): 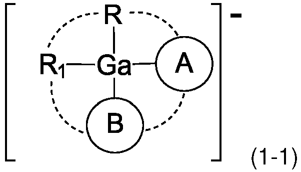 with
• A, and B independently being substituted or non-substituted heterocyclic rings, preferably aromatic heterocycles which preferably comprise one or more nitrogen ring atoms, and
• R and R1 independently in each instance representing hydrogen, deuterium, or organyl groups, and
• broken lines between the rings A and B and between the ring B and an organyl fragment R₁, and between the ring A and an organyl fragment R, and between two organyl fragments R and R₁ indicate each independently either that those respective organyl fragments A, B, R and R₁ are not connected at any position, or that those respective organyl fragments A, B, R and R₁ are directly connected through a chemical bond at any available position of each, or that those respective organyl fragments A, B, R and R₁ are connected via a linking group at any available position of each.

12. The coordination compound of claim 11, with the at least one lanthanide cation being selected from the group consisting of La(III), Ce(IV), Ce(III), Pr(III), Nd(III), Sm(III), Eu(II), Eu(III), Gd(III), Tb(III), Dy(III), Ho(III), Er(III), Tm(III), Yb(II), Yb(III), or Lu(III), preferably Ce(lll) and Gd(III).

13. The coordination compound of claim 12, in which the at least one lanthanide cation is threefold electrically positively charged and coordinated by three identical or different electrically negatively charged gallium compounds of general formula (1-1) as ligands, preferably the three electrically negatively charged gallium compounds of general formula (1-1) as ligand being identical to each other, more preferably the rings A and B in general formula (1-1) being identical to each other, or
with the at least one lanthanide cation being threefold electrically positively charged and coordinated by two identical or different electrically negatively charged gallium compounds of general formula (1-1) and a third singly electrically negatively charged compound which is not a gallium compound as ligands, preferably the two electrically negatively charged gallium compounds of general formula (1-1) being identical to each other, more preferably the rings A and B present in formula (1-1) of the electrically negatively charged gallium compounds of general formula (1-1) being identical to each other, and preferably the third singly electrically negatively charged compound being preferably identical to the rings A, or B present in formula (1-1) of the electrically negatively charged gallium compounds of general formula (1-1), or being a substituted ring A or B thereof.

14. The coordination compound of one of claims 11 to 13, which is selected from formulae C1 to C15:

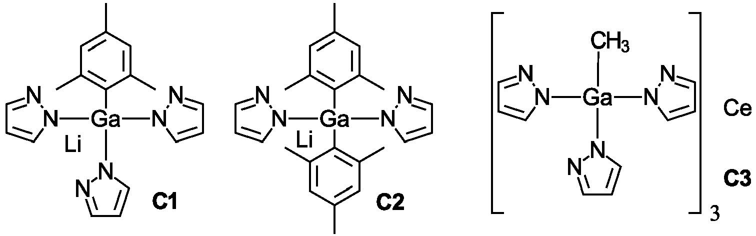

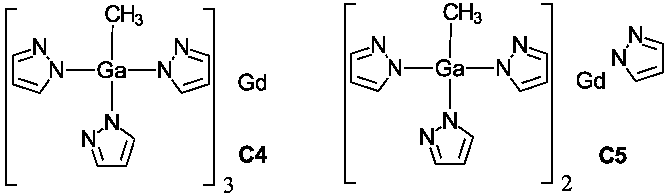

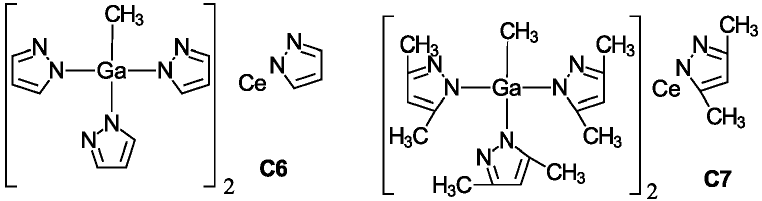

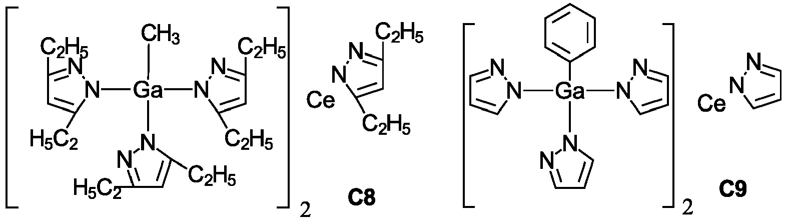

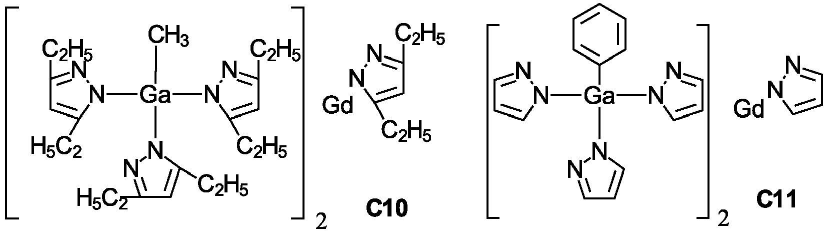

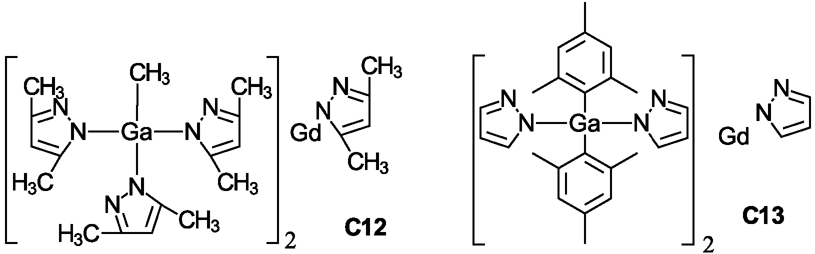

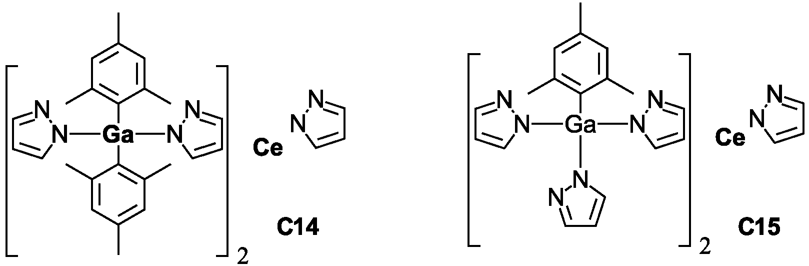

15. A process for preparing the electroluminescent device according to one of claims 1 to 10, wherein the organic layer comprising the charge-neutral metal-organic coordination compound is deposited from a gas phase, preferably using an evaporation and/or sublimation and/or carrier gas process, or is deposited by deposition from solution.

## Amended claims

### Amended claims in accordance with Rule 137(2) EPC.

1. An organic electroluminescent device (100) comprising:
a first electrode (104),
a second electrode (108), and
an organic layer (106) disposed between the first electrode and the second electrode (104, 108),
the organic layer (106) comprising at least one charge-neutral metal-organic coordination compound, with the metal-organic coordination compound comprising at least one electrically negatively charged gallium compound of general formula (1-1): 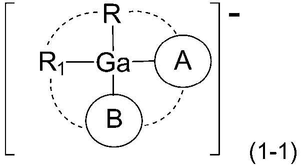
with
• **R** and **R₁** independently in each instance representing hydrogen, deuterium, or organyl groups, and
• **broken lines** between the rings A and B and between the ring B and an organyl fragment R₁, and between the ring A and an organyl fragment R, and between two organyl fragments R and R₁ indicate each independently either that those respective organyl fragments A, B, R and R₁ are not connected at any position, or that those respective organyl fragments A, B, R and R₁ are directly connected through a chemical bond at any available position of each, or that those respective organyl fragments A, B, R and R₁ are connected via a linking group at any available position of each,
**characterized in that A** and **B** independently are substituted or non-substituted heterocyclic rings, preferably aromatic heterocycles which preferably comprise one or more nitrogen ring atoms.

2. The electroluminescent device (100) of claim 1, with at least one, preferably both, of the rings A and/or B independently, preferably identically, being selected from the group consisting of substituted or non-substituted imidazole-2-yl, imidazole-4-yl, pyrazolyl, 1,2,3-triazolyl, 1,2,4-triatolyl, thiazolyl, isothiazolyl, oxazolyl, 1,3,4-oxadiazole-yl, and 1,2,4-thiadiazolyl.

3. The electroluminescent device (100) of claim 1 or 2, with both rings A and B being identically substituted pyrazolyl, preferably with substitutions in 3- and 5- position, and even more preferably with an identical substituent in the 3- and the 5- position, and even more preferably the substituent being alkyl or heteroalkyl, most preferably methyl or ethyl.

4. The electroluminescent device (100) of one of claims 1 to 3, with R and R₁ each independently being selected from substituted or non-substituted alkyl, preferably non-substituted alkyl, most preferably methyl, ethyl, or propyl, or being selected from substituted or non-substituted aryl or heteroaryl, preferably pyrazolyl or phenyl, the phenyl preferably being a mesityl.

5. The electroluminescent device (100) of one of claims 1 to 4, with the metal-organic coordination compound comprising at least one electrically negatively charged gallium compound of general formula (1-4) 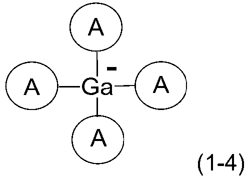
with A being identical, substituted or non-substituted heterocyclic rings, preferably aromatic heterocycles, preferably comprising one or more nitrogen ring atoms more preferably being substituted or non-substituted pyrazolyl,
or with the metal-organic coordination compound comprising at least one electrically negatively charged gallium compound of general formula (1-2): 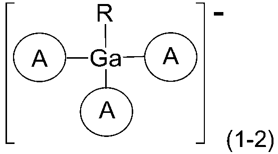
with A being identical, substituted or non-substituted heterocyclic rings, preferably aromatic heterocycles, preferably comprising one or more nitrogen ring atoms more preferably being substituted or non-substituted pyrazolyl, R representing hydrogen, deuterium, or an organyl groupl, preferably aryl, more preferably mesityl,
or with the metal-organic coordination compound comprising at least one electrically negatively charged gallium compound of general formula (1-3): 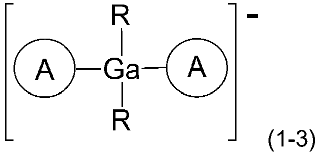
with both **A** being identical, substituted or non-substituted heterocyclic rings, preferably aromatic heterocycles, preferably comprising one or more nitrogen ring atoms , more preferably substituted or non-substituted pyrazolyl, both **R** being identical, representing hydrogen, deuterium, or organyl groups, preferably aryl, more preferably mesityl.

6. The electroluminescent device (100) of one of claims **1** to 5, with the at least one electrically negatively charged gallium compound present as part of the charge-neutral metal-organic coordination compound being selected from G1 to G15:

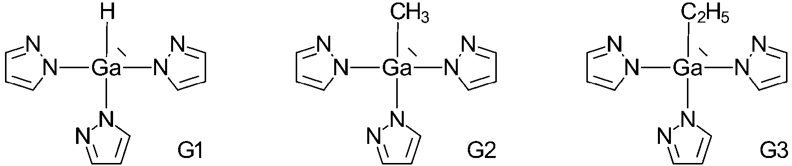

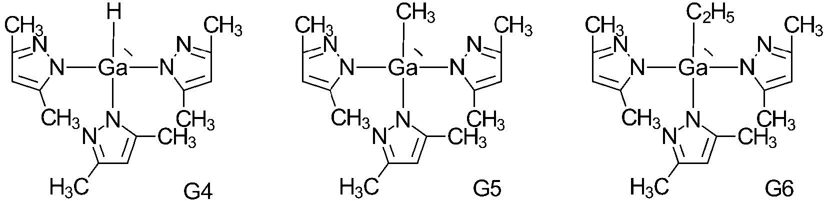

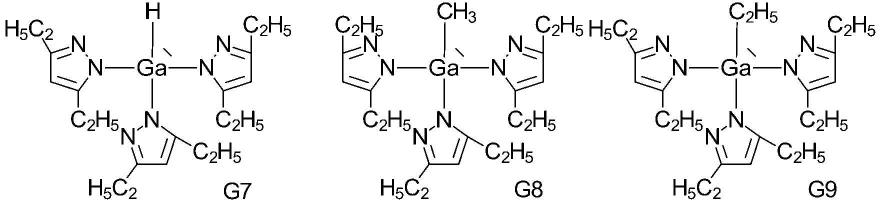

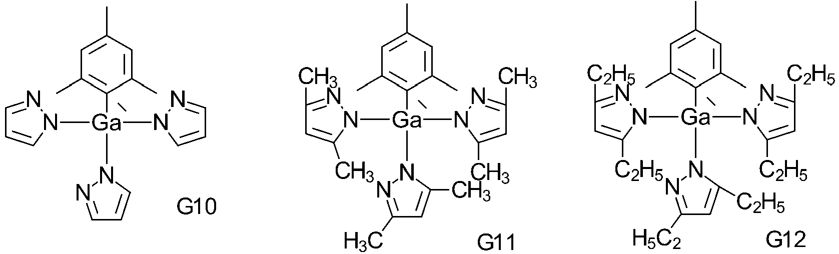

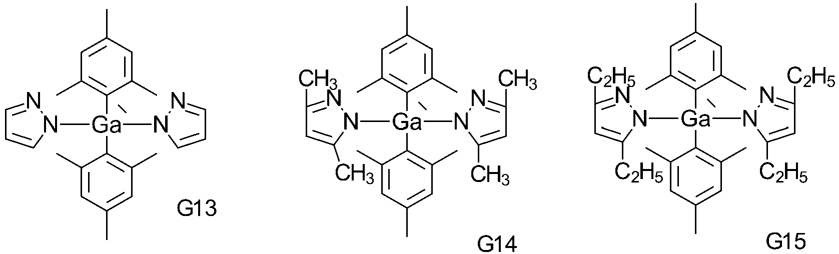

7. The electroluminescent device (100) of one of claims 1 to 6, with the charge-neutral metal-organic coordination compound comprising at least one additional metal besides the gallium of the electrically negatively charged gallium compound, with this at least one additional metal being electrically positively charged, and preferably being selected from the group consisting of alkali metals, alkali earth metals, lanthanides, and transition metals, preferably being selected from the group consisting of alkali metals and lanthanides, preferably with the at least one additional metal cation, present as part of the metal-organic coordination compound being twofold or higher electrically positively charged and with the metal-organic coordination compound comprising one or more charge-neutral or electrically negatively charged ligands, which are different from the electrically negatively charged gallium compounds of formulae (1-1), (1-2) and (1-3).

8. The electroluminescent device (100) of claim 7, with the at least one additional metal cation being threefold positively charged and with the coordination compound comprising two, preferably identical, electrically negatively charged gallium compounds according to formula (1-1), (1-2) or (1-3) as ligands and a third singly electrically negatively charged ligand, which is preferably identical to the ring A or B present in any of the formulae (1-1), (1-2) or (1-3), or is a substituted ring A or B thereof.

9. The electroluminescent device (100) of one of claims 1 to 8, with the organic layer (106) disposed between the first electrode and the second electrode (104, 108) additionally comprising at least one phosphorescent light emitting material which preferably emits substantially in the blue spectral region and/or comprises a metal cation selected from Pt(ll) and Ir(III).

10. The electroluminescent device (100) of one of claims 1 to 9, with the organic layer (106) disposed between the first electrode and the second electrode (104, 108) additionally comprising at least one fluorescent, hyperfluorescent, or TADF-type emitting organic material, preferably the fluorescent material comprising one or more six-membered heteroaryl or heteralkyl rings which preferably comprise one or more boron atoms in combination with nitrogen and/or oxygen atoms as part of the ring-forming atoms.

11. A charge-neutral metal-organic coordination compound comprising at least one lanthanide cation with the at least one lanthanide cation being coordinated by at least one electrically negatively charged gallium compound of general formula (1-1) as ligand compound of general formula (1-1): 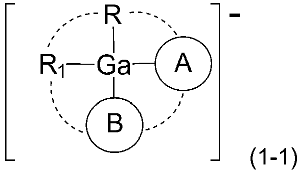 with
• R and R₁ independently in each instance representing hydrogen, deuterium, or organyl groups, and
• broken lines between the rings A and B and between the ring B and an organyl fragment R₁, and between the ring A and an organyl fragment R, and between two organyl fragments R and R₁ indicate each independently either that those respective organyl fragments A, B, R and R₁ are not connected at any position, or that those respective organyl fragments A, B, R and R₁ are directly connected through a chemical bond at any available position of each, or that those respective organyl fragments A, B, R and R₁ are connected via a linking group at any available position of each,
**characterized in that A** and **B** independently are substituted or non-substituted heterocyclic rings, preferably aromatic heterocycles which preferably comprise one or more nitrogen ring atoms.

12. The coordination compound of claim 11, with the at least one lanthanide cation being selected from the group consisting of La(III), Ce(IV), Ce(III), Pr(III), Nd(III), Sm(III), Eu(II), Eu(III), Gd(III), Tb(III), Dy(III), Ho(III), Er(III), Tm(III), Yb(II), Yb(III), or Lu(III), preferably Ce(III) and Gd(III).

13. The coordination compound of claim 12, in which the at least one lanthanide cation is threefold electrically positively charged and coordinated by three identical or different electrically negatively charged gallium compounds of general formula (1-1) as ligands, preferably the three electrically negatively charged gallium compounds of general formula (1-1) as ligand being identical to each other, more preferably the rings A and B in general formula (1-1) being identical to each other, or
with the at least one lanthanide cation being threefold electrically positively charged and coordinated by two identical or different electrically negatively charged gallium compounds of general formula (1-1) and a third singly electrically negatively charged compound which is not a gallium compound as ligands, preferably the two electrically negatively charged gallium compounds of general formula (1-1) being identical to each other, more preferably the rings A and B present in formula (1-1) of the electrically negatively charged gallium compounds of general formula (1-1) being identical to each other, and preferably the third singly electrically negatively charged compound being preferably identical to the rings A, or B present in formula (1-1) of the electrically negatively charged gallium compounds of general formula (1-1), or being a substituted ring A or B thereof.

14. The coordination compound of one of claims 11 to 13, which is selected from formulae C1 to C15:

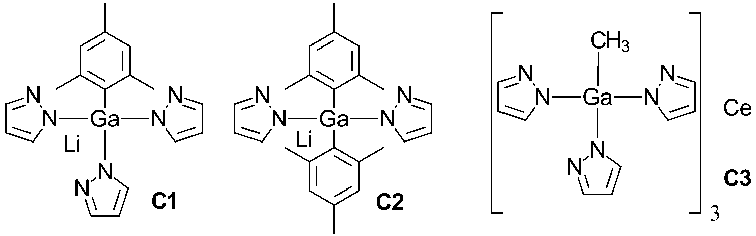

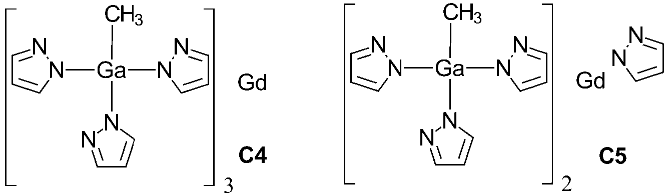

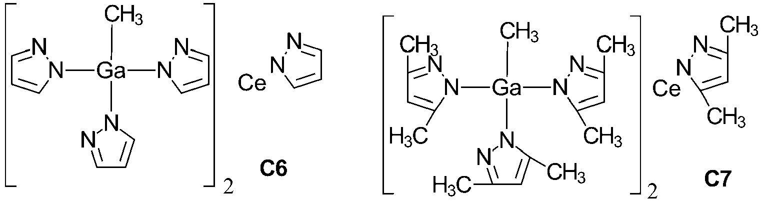

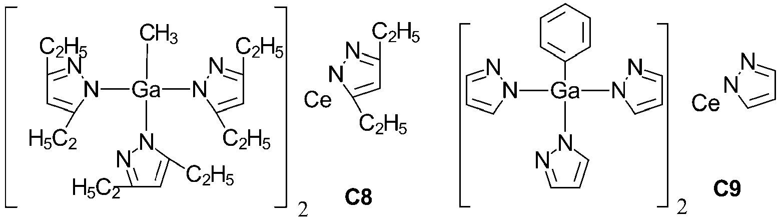

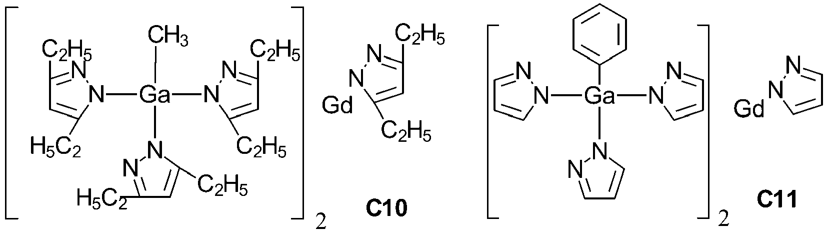

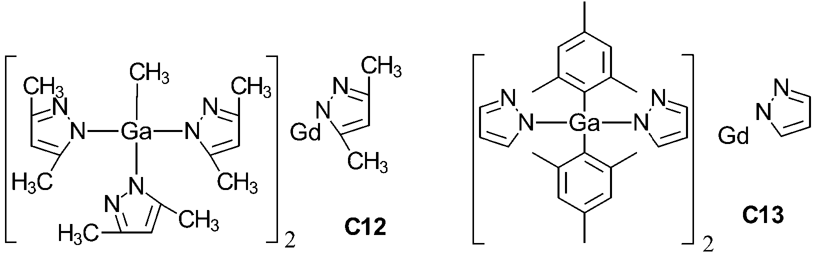

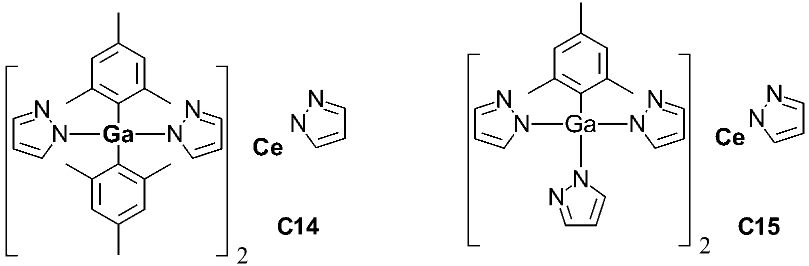

15. A process for preparing the electroluminescent device (100) according to one of claims 1 to 10, wherein the organic layer (106) comprising the charge-neutral metal-organic coordination compound is deposited from a gas phase, preferably using an evaporation and/or sublimation and/or carrier gas process, or is deposited by deposition from solution.
